# EUROPEAN PATENT APPLICATION

(11) **EP 3 297 010 A1**
(43) Date of publication of application: **21.03.2018**
(21) Application number: 16792750.8
(22) Date of filing: 12.05.2016
(51) Int. Cl.: H01G 9/20

(54) **DYE-SENSITIZED SOLAR CELL HAVING COUNTER ELECTRODE THAT IS PROVIDED WITH COLLECTOR ELECTRODE**

(30) Priority: 14.05.2015 JP 2015099288
(71) Applicant: Showa Co., Ltd., Ikoma-shi, Nara 630-0142 (JP)
(72) Inventor: TAKAYASU, Teruki, Ikoma-shi Nara 630-0142 (JP)
(74) Representative: Vossius & Partner Patentanwälte Rechtsanwälte mbB
(86) International application number: PCT/JP2016/064175
(87) International publication number: WO 2016/182025

(57) **Abstract**

Provided is a dye-sensitized solar cell with a large area that can exhibit high electrical power. The dye-sensitized solar cell is a dye-sensitized solar cell in which a photoelectrode and a counter electrode are disposed opposite to each other via an electrolyte layer; (1) the photoelectrode comprising a titanium material and a titanium oxide layer containing a dye sensitizing agent formed on the titanium material; and (2) the counter electrode comprising a transparent conductive glass or transparent conductive film coated with an electrochemical-reduction catalyst layer, the counter electrode being provided with a collector electrode.

## Description

### Technical Field

The present invention relates to a dye-sensitized solar cell.

### Background Art

There are various types of solar cells, including monocrystal, polycrystal, and amorphous silicon solar cells, CIGS, CdTe, GaAs, and other compound semiconductor solar cells, organic thin film solar cells, dye-sensitized solar cells, and the like.

Silicon solar cells are currently mainstream. However, silicon solar cells require high-purity silicon materials. Moreover, the production of silicon solar cells requires a high temperature and a high vacuum, causing high production costs. Thus, there is room for improvement in this respect.

Under such circumstances, dye-sensitized solar cells have recently been attracting attention. Dye-sensitized solar cells can be easily produced because of their simple structure, and there are many constituent materials thereof. Moreover, dye-sensitized solar cells can be produced at a low cost, and have high photoelectric conversion efficiency. For these reasons, dye-sensitized solar cells have been attracting attention as next-generation solar cells.

A dye-sensitized solar cell can be constructed by a simple method in which an electrolyte solution having reversible electrochemical redox characteristics is injected between a photoelectrode and a counter electrode, and the photoelectrode and the counter electrode are sealed and wire-connected.

The photoelectrode is conventionally produced in the following manner.

First, a paste agent containing titanium oxide particles is coated on the surface of transparent conductive glass, which is a glass substrate on which a transparent conductive film, such as ITO (indium tin oxide) or FTO (fluorine tin oxide), is formed. Then, the obtained coated product is heated at a temperature of 400 to 500°C, thereby producing an electrode having a porous titanium oxide layer.

Subsequently, the obtained electrode is immersed in an organic solution containing a dye sensitizing agent, such as ruthenium-based dye or indoline-based dye, thereby producing a photoelectrode in which the dye sensitizing agent is adsorbed to the surface of the porous titanium oxide.

Next, the counter electrode is generally produced by forming a platinum layer having an electrochemical reduction action by sputtering, etc., on a glass substrate or film on which a transparent conductive film is formed.

In conventional dye-sensitized solar cells, however, transparent conductive films that constitute photoelectrodes and counter electrodes have relatively high electrical resistance. Accordingly, there is room for improvement in terms of the significant reduction in the photoelectric conversion efficiency of dye-sensitized solar cells with a larger titanium oxide-coated area (area of transparent conductive film).

Moreover, the electrical resistance of the transparent conductive film is increased by heat treatment during the production of the porous titanium oxide layer (titanium oxide sintered body). Accordingly, there is room for improvement in terms of the reduction in the photoelectric conversion efficiency of dye-sensitized solar cells.

Under such circumstances, techniques to use metal titanium as a photoelectrode substrate have been examined. According to these techniques, electrical resistance is lower than that of glass substrates on which conventional transparent conductive films are formed; photoelectric conversion efficiency is higher than that of dye-sensitized solar cells using conventional transparent conductive films, particularly those having a large area of titanium oxide coating; and corrosion resistance to iodine, etc., contained in electrolyte solutions used in dye-sensitized solar cells is imparted.

However, in the techniques to use metal titanium as a photoelectrode substrate, it was necessary to irradiate light from the counter electrode side because metal titanium did not transmit light.

For example, PTL 1 discloses a technique to use a counter electrode having an opening using platinum in a mesh shape because a substrate made of metal, such as metal titanium, a titanium alloy, or stainless steel, is used as a photoelectrode.

However, the technique of PTL 1 used electrodes not using a transparent conductive film, and had a problem of low photoelectric conversion efficiency.

Excited electrons generated from the photo-absorbed dye move to the photoelectrode substrate through the porous titanium oxide layer to which the dye is adsorbed. The excited electrons moved to the photoelectrode move to the counter electrode via an external circuit. The excited electrons moved to the counter electrode reduce the electrolyte solution. In contrast, the dye, which has released electrons and been in an oxidation state, oxidizes the electrolyte solution.

The dye-sensitized solar cell generates electricity by repeating this series of flow. In the process of moving to the photoelectrode substrate through the porous titanium oxide layer to which the dye is adsorbed, the excited electrons generated from the dye recombine with the dye in an oxidation state, or undergo reverse transfer from the surface of the photoelectrode substrate in contact with the electrolyte solution to the electrolyte solution side. As a result, there was a problem such that conversion efficiency was reduced.

In order to solve this problem, a technique to form a block layer on the photoelectrode substrate is proposed. The block layer prevents reverse electron transfer from the surface of the photoelectrode substrate in contact with the electrolyte solution to the electrolyte solution side.

For example, PTL 2 discloses a technique to improve the conversion efficiency of a dye-sensitized solar cell by using a technique to coat a photoelectrode substrate, which is a glass substrate coated with a transparent conductive film, with an oxide, such as niobium oxide, magnesium oxide, or aluminium oxide.

However, there was a problem such that the conversion efficiency was only improved from 3.47% to about 4.48%, even when such treatment was performed. This is because, in conventional dye-sensitized solar cells, the electrical resistance of the transparent conductive film that forms the photoelectrode is relatively high. As a result, there was a problem such that the conversion efficiency was only slightly improved even when an oxide layer called a block layer was formed on the transparent conductive film.

### Citation List

### Patent Literature

PTL 1: JP2010-055935A
PTL 2: JP2008-077924A

### Summary of Invention

### Technical Problem

An object of the present invention is to provide a dye-sensitized solar cell with a large area that can exhibit high electrical power.

### Solution to Problem

As a result of intensive studies to solve the problems of the prior art, the present inventor found that the above object can be achieved by a dye-sensitized solar cell having a specific structure.

Specifically, the present invention relates to the following dye-sensitized solar cells.

Item 1:
   A dye-sensitized solar cell in which a photoelectrode and a counter electrode are disposed opposite to each other via an electrolyte layer;
      (1) the photoelectrode comprising a titanium material and a titanium oxide layer containing a dye sensitizing agent formed on the titanium material; and
      (2) the counter electrode comprising a transparent conductive glass or transparent conductive film coated with an electrochemical-reduction catalyst layer, the counter electrode being provided with a collector electrode.
Item 2:
   The dye-sensitized solar cell according to Item 1, wherein the counter electrode comprises a transparent conductive glass or transparent conductive film provided with a collector electrode, and further coated with an electrochemical-reduction catalyst layer.
Item 3:
   The dye-sensitized solar cell according to Item 1 or 2, wherein the titanium material is a material selected from the group consisting of metal titanium, titanium alloys, surface-treated metal titanium, and surface-treated titanium alloys.
Item 4:
   The dye-sensitized solar cell according to any one of Items 1 to 3, wherein the collector electrode provided in the counter electrode is a material selected from the group consisting of highly corrosion-resistant materials.
Item 5:
   The dye-sensitized solar cell according to any one of Items 1 to 4, wherein the collector electrode provided in the counter electrode is at least one material selected from:
      metal selected from the group consisting of gold, silver, copper, platinum, rhodium, palladium, iridium, aluminum, nickel, titanium, niobium, tantalum, zirconium, tungsten, nickel, chromium, and molybdenum;
      an alloy comprising metal mentioned above as a main component;
      a carbon material selected from the group consisting of carbon, graphite, carbon nanotubes, and fullerenes; or
      a conductive polymer material selected from the group consisting of polythiophenes.
Item 6:
   The dye-sensitized solar cell according to any one of Items 1 to 5, wherein the highly corrosion-resistant material provided in the collector electrode provided in the counter electrode is a material selected from the group consisting of metal titanium and titanium alloys.
Item 7:
   The dye-sensitized solar cell according to any one of Items 1 to 6, wherein the collector electrode has an opening with an area of 50 to 99% of the entire area of the counter electrode.
Item 8:
   The dye-sensitized solar cell according to any one of Items 1 to 7, wherein the collector electrode has a thickness of 0.01 to 100 µm.
Item 9:
   The dye-sensitized solar cell according to any one of Items 1 to 8, wherein the titanium oxide layer has a rectangular shape.
Item 10:
   The dye-sensitized solar cell according to any one of Items 1 to 9, wherein the electrochemical-reduction catalyst layer is a platinum catalyst layer.
Item 11:
   The dye-sensitized solar cell according to any one of Items 1 to 10, wherein the transparent conductive glass or transparent conductive film of the counter electrode is subjected to antireflection-film formation.
Item 12:
   The dye-sensitized solar cell according to any one of Items 1 to 11, wherein the counter electrode further comprises an antireflection film on a light irradiation surface of the transparent conductive glass or transparent conductive film.
Item 13:
   The dye-sensitized solar cell according to any one of Items 1 to 12, wherein a light-concentrating device is disposed on the counter electrode side.
Item 14:
   The dye-sensitized solar cell according to any one of Items 1 to 12, wherein the photoelectrode comprises a titanium material, a blocking layer formed on the titanium material, and a titanium oxide layer containing a dye sensitizing agent formed on the blocking layer.
Item 15:
   The dye-sensitized solar cell according to Item 14, wherein the blocking layer is at least one material layer selected from the group consisting of a layer of titanium oxide, a layer of aluminium oxide, a layer of silicon oxide, a layer of zirconium oxide, a layer of strontium titanate, a layer of magnesium oxide, and a layer of niobium oxide.
Item 16:
   The dye-sensitized solar cell according to Item 14, wherein the blocking layer comprises at least two layers selected from the group consisting of a layer of titanium oxide, a layer of aluminium oxide, a layer of silicon oxide, a layer of zirconium oxide, a layer of strontium titanate, a layer of magnesium oxide, and a layer of niobium oxide.
Item 17:
   The dye-sensitized solar cell according to Item 14, wherein the blocking layer comprises at least two layers selected from the group consisting of a layer of titanium oxide, a layer of aluminium oxide, and a layer of niobium oxide.
Item 18:
   The dye-sensitized solar cell according to any one of Items 1 to 17, wherein the titanium material of the photoelectrode is produced by the following surface treatment method comprising the steps of:
      (1) forming titanium nitride on the surface of a metal titanium material or titanium alloy material; and
      (2) anodizing the metal titanium material or titanium alloy material with the titanium nitride formed on the surface thereof obtained in step (1) using an electrolyte solution that has an etching effect on titanium at a voltage equal to or higher than spark discharge generating voltage, thereby forming an anatase-type titanium oxide film.
Item 19:
   The dye-sensitized solar cell according to any one of Items 1 to 17, wherein the titanium material of the photoelectrode is produced by the following surface treatment method comprising the steps of:
      (1) forming titanium nitride on the surface of a metal titanium material or titanium alloy material;
      (2) anodizing the metal titanium material or titanium alloy material with the titanium nitride formed on the surface thereof obtained in step (1) in an electrolyte solution that does not have an etching effect on titanium; and
      (3) heating the anodized metal titanium material or titanium alloy material obtained in step (2) in an oxidizing atmosphere, thereby forming an anatase-type titanium oxide film.
Item 20:
   The dye-sensitized solar cell according to Item 18 or 19, wherein the step of forming titanium nitride is performed by one treatment method selected from the group consisting of PVD treatment, CVD treatment, spraying treatment, heat treatment under an ammonia gas atmosphere, and heat treatment under a nitrogen gas atmosphere.
Item 21:
   The dye-sensitized solar cell according to Item 20, wherein the heat treatment under a nitrogen gas atmosphere is performed in the presence of an oxygen-trapping agent.
Item 22:
   A method for producing a dye-sensitized solar cell in which a photoelectrode and a counter electrode are disposed opposite to each other via an electrolyte layer; in the dye-sensitized solar cell,
      (1) the photoelectrode comprising a titanium material and a titanium oxide layer containing a dye sensitizing agent formed on the titanium material; and
      (2) the counter electrode comprising a transparent conductive glass or transparent conductive film coated with an electrochemical-reduction catalyst layer, the counter electrode being provided with a collector electrode;
   wherein the titanium material of the photoelectrode is produced by the following surface treatment method comprising the steps of:
      (1) forming titanium nitride on the surface of a metal titanium material or titanium alloy material; and
      (2) anodizing the metal titanium material or titanium alloy material with the titanium nitride formed on the surface thereof obtained in step (1) using an electrolyte solution that has an etching effect on titanium at a voltage equal to or higher than spark discharge generating voltage, thereby forming an anatase-type titanium oxide film.
Item 23:
   A method for producing a dye-sensitized solar cell in which a photoelectrode and a counter electrode are disposed opposite to each other via an electrolyte layer; in the dye-sensitized solar cell,
      (1) the photoelectrode comprising a titanium material and a titanium oxide layer containing a dye sensitizing agent formed on the titanium material; and
      (2) the counter electrode comprising a transparent conductive glass or transparent conductive film coated with an electrochemical-reduction catalyst layer, the counter electrode being provided with a collector electrode;
   wherein the titanium material of the photoelectrode is produced by the following surface treatment method comprising the steps of:
      (1) forming titanium nitride on the surface of a metal titanium material or titanium alloy material;
      (2) anodizing the metal titanium material or titanium alloy material with the titanium nitride formed on the surface thereof obtained in step (1) in an electrolyte solution that does not have an etching effect on titanium; and
      (3) heating the anodized metal titanium material or titanium alloy material obtained in step (2) in an oxidizing atmosphere, thereby forming an anatase-type titanium oxide film.

In the dye-sensitized solar cell, it is preferable that the photoelectrode and the counter electrode be disposed opposite to each other via the electrolyte layer, and that light be irradiated from the counter electrode side.

It is preferable that the counter electrode comprise a transparent conductive glass or transparent conductive film coated with an electrochemical-reduction catalyst layer, and that the counter electrode be provided with a collector electrode.

It is preferable that the material of the collector electrode be:
(i) metal selected from the group consisting of gold, silver, copper, platinum, rhodium, palladium, iridium, aluminum, nickel, titanium, niobium, tantalum, zirconium, chromium, and molybdenum;
(ii) an alloy material selected from the group consisting of titanium alloys, niobium alloys, tantalum alloys, zirconium alloys, chromium alloys, and molybdenum alloys;
(iii) a carbon material selected from the group consisting of carbon, graphite, carbon nanotubes, and fullerenes;
(iv) a conductive polymer material selected from the group consisting of polythiophenes; or
(v) a material selected from the group consisting of gold, silver, copper, nickel, and aluminum, each of which has a surface coated with titanium or a titanium alloy.

It is preferable that the material of the collector electrode be a titanium alloy, and be a material selected from the group consisting of Ti-6Al-4V, Ti-4.5Al-3V-2Fe-2Mo, Ti-0.5Pd, Ti-Ni, Ti-5Al-2.5Sn, Ti-8Al-1Mo-1V, Ti-3Al-2.5V, Ti-6Al-6V-2Sn, Ti-6Al-2Sn-4Zr-6Mo, Ti-3Al-2.5V-6Cr-4Zr-4Mo, Ti-10V-2Fe-3Al, Ti-15V-3Cr-3Sn-3Al, Ti-5Al-1Fe, Ti-0.5Cu, Ti-1Cu, Ti-1Cu-0.5Nb, Ti-3Al-5V, Ti-20V-4Al-1Sn, and Ti-22V-4Al.

It is preferable that in the dye-sensitized solar cell, the titanium material of the photoelectrode be produced by the following surface treatment method comprising the steps of:
(1) forming titanium nitride on the surface of a metal titanium material or titanium alloy material; and
(2) anodizing the metal titanium material or titanium alloy material with the titanium nitride formed on the surface thereof obtained in step (1) using an electrolyte solution that has an etching effect on titanium at a voltage equal to or higher than spark discharge generating voltage, thereby forming an anatase-type titanium oxide film.

It is preferable that in the dye-sensitized solar cell, the titanium material of the photoelectrode be produced by the following surface treatment method comprising the steps of:
(1) forming titanium nitride on the surface of a metal titanium material or titanium alloy material;
(2) anodizing the metal titanium material or titanium alloy material with the titanium nitride formed on the surface thereof obtained in step (1) in an electrolyte solution that does not have an etching effect on titanium; and
(3) heating the anodized metal titanium material or titanium alloy material obtained in step (2) in an oxidizing atmosphere, thereby forming an anatase-type titanium oxide film.

It is preferable that the dye-sensitized solar cell satisfy the following requirements:
(1) the photoelectrode comprises a titanium material and a titanium oxide layer containing a dye sensitizing agent formed on the titanium material;
(2) the counter electrode comprises a transparent conductive glass or transparent conductive film coated with ITO or FTO, and a platinum catalyst layer having a thickness of 0.5 to 1 nm formed on the film or glass, and the counter electrode is provided with a collector electrode;
(3) the electrolyte layer is a non-aqueous electrolyte containing a redox species, and the redox species includes a combination of iodine and one or more iodide salts selected from lithium iodide, sodium iodide, potassium iodide, or calcium iodide; and
(4) the collector electrode is wired in a stripe or mesh shape, the collector electrode has an opening with an area of 80 to 99% of the entire area of the counter electrode, the material of the collector electrode is Ti-Ni, which is a titanium alloy, and the collector electrode has a thickness of 1 µm to 100 µm.

### Advantageous Effects of Invention

The dye-sensitized solar cell of the present invention can exhibit high electrical power by providing a collector electrode, even if the cell has a large area.

### Brief Description of Drawings

Fig. 1 is a schematic view (cross-sectional view) showing one embodiment of the dye-sensitized solar cell of the present invention.
Fig. 2 is a schematic view (cross-sectional view) showing one embodiment of the counter electrode of the dye-sensitized solar cell of the present invention.
Fig. 3 is a schematic view (cross-sectional view) showing one embodiment of the dye-sensitized solar cell of the present invention.

### Description of Embodiments

The present invention is described in detail below.

In the present specification, materials selected from the group consisting of metal titanium, titanium alloys, surface-treated metal titanium, and surface-treated titanium alloys are also referred to as simply "titanium materials."

In the dye-sensitized solar cell of the present invention, a photoelectrode and a counter electrode are disposed opposite to each other via an electrolyte layer;
(1) the photoelectrode comprising a titanium material and a titanium oxide layer containing a dye sensitizing agent formed on the titanium material; and
(2) the counter electrode comprising a transparent conductive glass or transparent conductive film coated with an electrochemical-reduction catalyst layer, the counter electrode being provided with a collector electrode.

The counter electrode preferably comprises a transparent conductive glass or transparent conductive film provided with a collector electrode, and further coated with an electrochemical-reduction catalyst layer.

Since the photoelectrode of the dye-sensitized solar cell of the present invention is made of a titanium material that does not transmit light, light is irradiated from the counter electrode side. Further, a dye-sensitized solar cell having a large area can also exhibit high electrical power by using a collector electrode on the counter electrode.

The dye-sensitized solar cell of the present invention comprises the following members.

### (1) Photoelectrode

In the dye-sensitized solar cell, a photoelectrode and a counter electrode are disposed opposite to each other via an electrolyte layer. The photoelectrode is obtained by forming a titanium oxide layer containing a dye sensitizing agent on a material selected from the group consisting of metal titanium, titanium alloys, surface-treated metal titanium, and surface-treated titanium alloys (hereinafter also referred to as "titanium material"; photoelectrode substrate).

### Photoelectrode Substrate

A titanium material itself can be used as the photoelectrode substrate. A titanium material serves as a substrate.

Metal titanium material is titanium itself. When a titanium alloy material is used, its type is not particularly limited. Examples of titanium alloys include Ti-6Al-4V, Ti-4.5Al-3V-2Fe-2Mo, Ti-0.5Pd, Ti-Ni, Ti-5Al-2.5Sn, Ti-8Al-1Mo-1V, Ti-3Al-2.5V, Ti-6Al-6V-2Sn, Ti-6Al-2Sn-4Zr-6Mo, Ti-3Al-2.5V-6Cr-4Zr-4Mo, Ti-10V-2Fe-3Al, Ti-15V-3Cr-3Sn-3Al, Ti-5Al-1Fe, Ti-0.5Cu, Ti-1Cu, Ti-1Cu-0.5Nb, Ti-3Al-5V, Ti-20V-4Al-1Sn, Ti-22V-4Al, and the like.

The photoelectrode substrate is preferably one in which a titanium material is treated by the following surface treatment method A or B to form an anatase-type titanium oxide film on the surface of the titanium material, because, for example, when electrons generated due to light excitation of the dye sensitizing agent are transferred from the titanium oxide layer to the photoelectrode substrate, reverse electron transfer, such as leakage of the electrons into the electrolyte solution layer, is prevented.

The anatase-type titanium oxide film serves as a semiconductor layer.

When metal titanium or a titanium alloy is used as the photoelectrode substrate, a paste agent containing titanium oxide particles is coated in the formation of a titanium oxide layer (semiconductor layer) containing a dye sensitizing agent.

Subsequently, a step of performing heat treatment of the obtained coated product at a temperature of 400 to 500°C is performed. In the step of heat treatment at a temperature of 400 to 500°C, a titanium oxide layer is formed on the surface of the metal titanium or titanium alloy. This titanium oxide layer can also prevent reverse electron transfer, such as leakage of the electrons into the electrolyte solution layer.

The thickness of the photoelectrode substrate is generally about 0.01 to 10 mm, preferably about 0.01 to 5 mm, and more preferably about 0.05 to 1 mm.

### Surface Treatment Method A

The photoelectrode substrate (titanium material for the photoelectrode) is preferably a photoelectrode substrate having a semiconductor layer containing anatase-type titanium oxide on the surface thereof, produced by the following surface treatment method comprising the steps of:

(1) forming titanium nitride on the surface of a metal titanium material or titanium alloy material; and
(2) anodizing the metal titanium material or titanium alloy material with titanium nitride formed on the surface thereof obtained in step (1) using an electrolyte solution that has an etching effect on titanium at a voltage equal to or higher than the spark discharge generating voltage, thereby forming an anatase-type titanium oxide film.

### Surface Treatment Method B

The photoelectrode substrate (titanium material for the photoelectrode) is preferably a photoelectrode substrate having a semiconductor layer containing anatase-type titanium oxide on the surface thereof, produced by the following surface treatment method comprising the steps of:

(1) forming titanium nitride on the surface of a metal titanium material or titanium alloy material;
(2) anodizing the metal titanium material or titanium alloy material with titanium nitride formed on the surface thereof obtained in step (1) in an electrolyte solution that does not have an etching effect on titanium; and
(3) heating the anodized metal titanium material or titanium alloy material obtained in step (2) in an oxidizing atmosphere, thereby forming an anatase-type titanium oxide film.

### Step (1) of Surface Treatment Methods A and B

In the step of forming titanium nitride on the surface of a titanium material (metal titanium or titanium alloy) (step (1)), a layer of titanium nitride generally with a thickness of about 0.1 to 100 µm can be formed on the surface of a titanium material.

The thickness of the titanium nitride layer is preferably about 0.5 to 50 µm, and more preferably about 1 to 10 µm.

The means for forming titanium nitride on the surface of a titanium material is not particularly limited. For example, titanium nitride is physically or chemically attached to the surface of a titanium material, or titanium and nitrogen are reacted on the surface of a titanium material to thereby form titanium nitride.

The step of forming titanium nitride is preferably performed by one treatment method selected from the group consisting of PVD (physical vapor deposition) treatment, CVD (chemical vapor deposition) treatment, spraying treatment (film formation by spraying), heat treatment under an ammonia gas atmosphere, and heat treatment under a nitrogen gas atmosphere.

Examples of the PVD treatment include ion plating, sputtering, and the like. Examples of the CVD treatment include thermal CVD treatment, plasma CVD treatment, laser CVD treatment, and the like. Examples of the spraying treatment include flame spraying, arc spraying, plasma spraying, laser spraying, and the like.

The heating temperature of the heat treatment under an ammonia gas or nitrogen gas atmosphere is preferably about 500°C or more, more preferably about 750 to 1,050°C, and even more preferably about 750°C to 950°C. It is preferable to heat a titanium material generally at about 500°C or more (preferably about 750°C or more) under a nitrogen gas atmosphere.

The heat treatment under an ammonia gas or nitrogen gas atmosphere is preferably performed in the presence of an oxygen-trapping agent.

It is particularly preferable to form titanium nitride by performing heat treatment under a nitrogen gas atmosphere in the presence of an oxygen-trapping agent.

The oxygen-trapping agent used in the heat treatment of a titanium material is, for example, a substance or gas having a higher oxygen affinity than that of the titanium material. For example, a carbon material, metal powder, hydrogen gas, etc., can be preferably used. These oxygen-trapping agents may be used singly or in a combination of two or more.

Examples of carbon materials include, but are not particularly limited to, graphite carbon, amorphous carbon, carbon having an intermediate crystal structure between graphite carbon and amorphous carbon, and the like. The carbon material may have any shape, such as plate, foil, or powder.

It is preferable to use a plate carbon material, in terms of handling properties, and because the thermal strain of the titanium material during heat treatment can be prevented.

Examples of metal powders include, but are not particularly limited to, metal powders of titanium, a titanium alloy, chromium, a chromium alloy, molybdenum, a molybdenum alloy, vanadium, a vanadium alloy, tantalum, a tantalum alloy, zirconium, zirconium, a zirconium alloy, silicon, a silicon alloy, aluminum, an aluminum alloy, or the like. It is preferable to use a metal powder of titanium, a titanium alloy, chromium, a chromium alloy, zirconium, a zirconium alloy, aluminum, an aluminum alloy, or the like, because their oxygen affinity is high. The most preferable metal powder is a metal powder of titanium particles or a titanium alloy. These metal powders may be used singly or in a combination of two or more.

The average particle diameter of the metal powder is preferably about 0.1 to 1,000 µm, more preferably about 0.1 to 100 µm, and even more preferably about 0.1 to 10 µm.

The conditions for using an oxygen-trapping agent in an ammonia gas or nitrogen gas atmosphere can be suitably determined depending on the type and shape of the oxygen-trapping agent.

When a carbon material or metal powder is used as the oxygen-trapping agent, a titanium material is brought into contact with the carbon material or metal powder so that the surface of the titanium material is covered with the carbon material or metal powder. Then, the titanium material is heated in an ammonia gas or nitrogen gas atmosphere.

When hydrogen gas is used as the oxygen-trapping agent, the titanium material is heated while hydrogen gas is introduced under an ammonia gas or nitrogen gas atmosphere.

The heat treatment can be performed in an atmosphere of ammonia gas, nitrogen gas, or a mixed gas of ammonia gas and nitrogen gas. It is most preferable to use nitrogen gas, in terms of convenience, profitability, and safety.

The reaction pressure of the heat treatment under an ammonia gas or nitrogen gas atmosphere is about 0.01 to 100 MPa, preferably about 0.1 to 10 MPa, and more preferably about 0.1 to 1 MPa. The heat treatment is preferably performed under a nitrogen gas atmosphere.

The heating time of the heat treatment under an ammonia gas or nitrogen gas atmosphere is preferably about 1 minute to 12 hours, more preferably about 10 minutes to 8 hours, and even more preferably about 1 hour to 6 hours. It is preferable to heat the titanium material for this period of time.

When a titanium material is heated under an ammonia gas or nitrogen gas atmosphere, it is preferable, in order to efficiently form titanium nitride on the surface of the titanium material, to reduce the pressure in the furnace for heat treatment using a rotary-type vacuum pump and optionally a mechanical booster pump or an oil diffusion pump, and to reduce the concentration of oxygen remaining in the furnace for heat treatment (in the nitriding furnace).

Titanium nitride can be efficiently formed on the surface of a titanium material by reducing the pressure in the furnace for heat treatment to preferably about 10 Pa or less, more preferably about 1 Pa or less, and even more preferably about 0.1 Pa or less.

Titanium nitride can be efficiently formed on the surface of a titanium material by supplying ammonia gas, nitrogen gas, or a mixed gas of ammonia gas and nitrogen gas, into the decompressed furnace to return the pressure in the furnace, and heating the titanium material. The heating temperature, heating time, and other conditions of the heat treatment using this furnace may be the same as the above-mentioned conditions. As the gas composition, it is most preferable to use nitrogen gas, in terms of convenience, profitability, and safety.

Titanium nitride can be more efficiently formed on the surface of a titanium material by alternately repeating (several times) the decompression treatment that reduces the remaining oxygen concentration in the furnace for heat treatment, and the pressure-returning treatment that supplies nitrogen gas, etc., into the furnace. Furthermore, titanium nitride can be more efficiently formed on the surface of a titanium material by performing decompression treatment in the presence of an oxygen-trapping agent, and heat treatment under a gas atmosphere, such as ammonia gas or nitrogen gas.

The type of titanium nitride formed on the surface of a titanium material is not particularly limited. Examples thereof include TiN, Ti₂N, α-TiN_{0.3}, η-Ti₃N₂₋ₓ, ξ-Ti₄N₃₋ₓ (provided that X is 0 or more and less than 3), mixtures thereof, amorphous titanium nitride, and the like. Preferred among these are TiN, Ti₂N, and mixtures thereof; more preferred are TiN, and a mixture of TiN and Ti₂N; and particularly preferred is TiN.

As the means for forming titanium nitride in the present invention, one of the above methods may be used singly, or two or more of them may be used in combination. Of the above methods for forming titanium nitride, heat treatment of a titanium material under a nitrogen gas atmosphere is preferred in terms of convenience, mass production, or production cost.

### Step (2) of Surface Treatment Method A

In surface treatment method A, the titanium material with titanium nitride formed on the surface thereof is anodized using an electrolyte solution that has an etching effect on titanium at a voltage equal to or higher than the spark discharge generating voltage, thereby forming an anatase-type titanium oxide film (step (2)).

The produced photoelectrode substrate has an anatase-type titanium oxide-containing semiconductor layer on the surface thereof. An anatase-type titanium oxide film can be suitably formed by performing anodization. Due to the formation of an anatase-type titanium oxide film, high photoelectric conversion efficiency can be suitably exhibited.

In the surface treatment using a method of applying a voltage equal to or higher than the spark discharge generating voltage, an electrolyte solution that has an etching effect on titanium materials is preferably used. The electrolyte solution preferably contains an inorganic acid and/or organic acid that have an etching effect on titanium. The electrolyte solution preferably further contains hydrogen peroxide. It is preferable to perform anodization by applying a voltage equal to or higher than the spark discharge generating voltage.

As the electrolyte solution, it is preferable to use an aqueous solution containing an inorganic acid and/or organic acid that have an etching effect on titanium materials.

Examples of the inorganic acid that has an etching effect on titanium materials include sulfuric acid, hydrofluoric acid, hydrochloric acid, nitric acid, aqua regia, and the like. Examples of the organic acid that has an etching effect on titanium include oxalic acid, formic acid, citric acid, trichloroacetic acid, and the like. These acids may be used singly, or in a combination of any two or more regardless of whether they are organic acids or inorganic acids.

A preferable embodiment of an electrolyte solution containing two or more acids is, for example, an aqueous solution containing sulfuric acid and optionally phosphoric acid. Although the proportion of the acids in this electrolyte solution varies depending on the type of acid used, anodization conditions, and other conditions, the total amount of the acids is generally 0.01 to 10 M, preferably 0.1 to 10 M, and more preferably 1 to 10 M. An example of an electrolyte solution containing sulfuric acid and phosphoric acid is an electrolyte solution containing 1 to 8 M sulfuric acid and 0.1 to 2 M phosphoric acid.

The electrolyte solution preferably contains hydrogen peroxide, in addition to the above organic acid and/or inorganic acid. The electrolyte solution containing hydrogen peroxide allows more efficient production of an anatase-type titanium oxide film. When the electrolyte solution contains hydrogen peroxide, the proportion of hydrogen peroxide is not particularly limited, but is, for example, 0.01 to 5 M, preferably 0.01 to 1 M, and more preferably 0.1 to 1 M.

A preferable embodiment of the electrolyte solution used in the anodization is, for example, an aqueous solution containing 1 to 8 M sulfuric acid, 0.1 to 2 M phosphoric acid, and 0.1 to 1 M hydrogen peroxide.

An anatase-type titanium oxide film is obtained by immersing a titanium material in the above electrolyte solution, and performing anodization by applying a constant current so that a voltage equal to or higher than the spark discharge generating voltage is applied. For example, the voltage equal to or higher than the spark discharge generating voltage is generally 100 V or more, and preferably 150 V or more.

The anodization can be performed, for example, by increasing the voltage to the above spark discharge generating voltage at a constant rate, and applying a constant voltage for a certain period of time at a voltage equal to or higher than the spark discharge generating voltage. The rate of increasing the voltage to the spark discharge generating voltage is generally 0.01 to 1 v/sec, preferably 0.05 to 0.5 v/sec, and more preferably 0.1 to 0.5 v/sec. Moreover, the time for applying a voltage equal to or higher than the spark discharge generating voltage is generally 1 minute or more, preferably 1 to 60 minutes, and more preferably 10 to 30 minutes.

The anodization by spark discharge can also be performed by controlling the current, in place of controlling the voltage. The current density in the anodization may be 0.1 A/dm² or more, but is preferably 1 A/dm² to 10 A/dm², in terms of profitability, convenience, and performance.

According to the above method, an anatase-type titanium oxide-containing film having a film thickness of about 1 to 100 µm can be obtained.

### Step (2) of Surface Treatment Method B

In surface treatment method B, the titanium material with titanium nitride formed on the surface thereof is anodized in an electrolyte solution that does not have an etching effect on titanium (step (2)). Then, the anodized titanium material is heated in an oxidizing atmosphere, thereby forming an anatase-type titanium oxide film (step (3)). The produced photoelectrode substrate has an anatase-type titanium oxide-containing semiconductor layer on the surface thereof, and suitably exhibits high photoelectric conversion efficiency.

The electrolyte solution preferably contains at least one acid selected from the group consisting of inorganic acids and organic acids that do not have an etching effect on titanium, or a salt compound thereof. An amorphous titanium oxide film can be formed on the surface of the titanium material with titanium nitride formed on the surface thereof, by anodizing the titanium material in an electrolyte solution that does not have an etching effect on titanium.

The electrolyte solution that does not have an etching effect on titanium is preferably an electrolyte solution containing at least one compound selected from the group consisting of inorganic acids, organic acids, and salts thereof (hereafter also referred to as "an inorganic acid or the like"). The electrolyte solution containing an inorganic acid or the like is preferably a dilute aqueous solution of phosphoric acid, phosphate, or the like.

Only performing step (2) of anodization in surface treatment method B does not generate spark discharges, and crystalline titanium oxide, such as anatase-type titanium oxide, is not generally formed.

Anatase-type titanium oxide can be formed from amorphous titanium oxide in the subsequent heat treatment step under an oxidizing atmosphere. Therefore, because an amorphous titanium oxide film is effectively formed on the surface of the titanium material, it is preferable to anodize the titanium material with titanium nitride formed on the surface thereof.

The electrolyte solution that does not have an etching effect on titanium is preferably an electrolyte solution containing at least one compound (inorganic acid, etc.) selected from the group consisting of inorganic acids (phosphoric acid, etc.), organic acids, and salts thereof (phosphate, etc.).

The inorganic acid that does not have an etching effect on titanium is preferably phosphoric acid, carbonic acid, or the like, in terms of convenience, profitability, safety, etc. The organic acid that does not have an etching effect on titanium is preferably acetic acid, adipic acid, lactic acid, or the like. Salts of these acids, such as sodium dihydrogenphosphate, disodium hydrogenphosphate, sodium hydrogencarbonate, sodium acetate, potassium adipate, and sodium lactate, can also be used.

In addition, it is preferable to use an electrolyte solution containing an electrolyte, such as sodium sulfate, potassium sulfate, magnesium sulfate, sodium nitrate, potassium nitrate, magnesium nitrate, or calcium nitrate.

The electrolyte solution that does not have an etching effect on titanium is preferably an electrolyte solution containing at least one compound (inorganic acid, etc.) selected from the group consisting of inorganic acids (phosphoric acid, etc.), organic acids, and salts thereof (phosphate, etc.). The most preferable inorganic acids, etc., are phosphoric acid and phosphate.

The electrolyte solution is preferably a dilute aqueous solution of an inorganic acid or the like. The concentration of the inorganic acid or the like in the electrolyte solution is preferably about 1 wt.%, in terms of profitability, etc. For example, in an electrolyte solution containing phosphoric acid, the concentration of the phosphoric acid is preferably about 0.01 to 10 wt.%, more preferably about 0.1 to 10 wt.%, and even more preferably about 1 to 3 wt.%.

These acids may be used singly, or in a combination of any two or more regardless of whether they are organic acids or inorganic acids. A preferable embodiment of an electrolyte solution containing two or more acids is, for example, an aqueous solution containing phosphate and phosphoric acid. Although the proportion of the acids in this electrolyte solution varies depending on the type of acid and acid salt used, anodization conditions, and other conditions, the total amount of the acids is generally 0.01 to 10 wt.%, preferably 0.1 to 10 wt.%, and more preferably 1 to 3 wt.%.

The titanium material with titanium nitride formed on the surface thereof obtained in the step of forming titanium nitride is immersed in a dilute electrolyte solution containing an inorganic acid or the like that does not have an etching effect on titanium. Subsequently, anodization is performed by preferably applying a voltage of about 10 to 300 V. It is more preferable to perform anodization at a voltage of about 50 to 300 V, and even more preferably about 50 to 200 V.

The anodization treatment temperature is preferably about 0 to 80°C, in terms of convenience, profitability, safety, etc. It is more preferable to perform anodization at a temperature of about 10 to 50°C, and even more preferably about 20 to 30°C.

The anodization treatment time is preferably about 1 second to 1 hour. It is more preferable to perform anodization for about 10 seconds to 30 minutes, and even more preferably about 5 minutes to 20 minutes.

### Step (3) of Surface Treatment Method B

Next, the titanium material with a titanium oxide film formed on the surface thereof is heated in an oxidizing atmosphere, thereby forming an anatase-type titanium oxide film (Step (3)).

When the metal titanium material, etc., is only heated in an oxidizing atmosphere, rutile-type titanium dioxide is formed, but anatase-type titanium oxide is not sufficiently formed.

The titanium material with titanium nitride formed thereon and with a titanium oxide film (amorphous titanium oxide film) formed thereon (titanium material after anodization) is heated in an oxidizing atmosphere (air oxidation treatment, etc.), thereby forming an anatase-type titanium oxide film, which has excellent photoelectric conversion characteristics among crystalline titanium oxides. As a result, the titanium material after heat treatment has excellent photoelectric conversion characteristics.

The oxidizing atmosphere in which heat treatment is performed may be selected from an air oxidizing atmosphere, an atmosphere of a mixture of oxygen gas and nitrogen gas having any oxygen concentration, an oxygen gas atmosphere, and the like; however, heat treatment in an air oxidizing atmosphere is preferred in terms of convenience, profitability, safety, etc.

The temperature of the heat treatment in an oxidizing atmosphere is preferably about 300°C or more, because of the efficient conversion from amorphous titanium oxide to anatase-type titanium oxide. The temperature of the heat treatment in an oxidizing atmosphere is preferably about 800°C or less, in order to prevent a phase transition from anatase-type titanium oxide to rutile-type titanium dioxide. This is because the photoelectric conversion characteristics of rutile-type titanium dioxide are inferior to those of anatase-type titanium oxide. The temperature of the heat treatment in an oxidizing atmosphere is more preferably about 300 to 800°C, even more preferably about 300 to 700°C, and particularly preferably about 400 to 700°C.

The reaction pressure of the heat treatment is about 0.01 to 10 MPa, preferably about 0.01 to 5 MPa, and more preferably about 0.1 to 1 MPa.

The heating time of the heat treatment is preferably about 1 minute to 12 hours, more preferably about 10 minutes to 8 hours, and even more preferably about 1 to 6 hours.

The crystalline titanium oxide film is preferably an anatase-type titanium oxide film. Open-voltage values are improved by using anatase-type titanium oxide, rather than rutile-type titanium dioxide, in a photoelectrode of a dye-sensitized solar cell; thus, the photoelectric conversion characteristics are also high. The heat treatment after the anodization of the present invention results in the formation of a film containing a large amount of anatase-type titanium oxide having high photoelectric conversion characteristics.

The heat treatment allows the production of photoelectric conversion element materials in which a large amount of highly active anatase-type titanium oxide is formed on the surface of the titanium materials. The materials can also be used as photoelectric conversion element materials that achieve high conversion efficiency.

According to the above method, an anatase-type titanium oxide-containing film having a film thickness of about 1 to 100 µm can be obtained.

An excellent photoelectric conversion element material can be produced by forming titanium nitride on the surface of a titanium material, and incorporating, after the formation of titanium nitride and before the heat treatment in an oxidizing atmosphere, the step of performing anodization in an electrolyte solution, such as a dilute aqueous acid solution of phosphoric acid or the like that does not have an etching effect on titanium, or an aqueous solution of a salt of phosphoric acid or the like.

Due to the anatase-type titanium oxide (film) formed on their surface, the titanium materials can be used as photoelectric conversion element materials, such as photoelectrode substrates, of dye-sensitized solar cells, which have been attracting attention as next-generation solar cells.

### Blocking Layer

The conversion efficiency of the dye-sensitized solar cell of the present invention can be significantly improved by forming the photoelectrode substrate from a titanium material, and further providing a blocking layer.

The blocking layer can not only prevent leakage of electrons to the electrolyte solution layer at the interface of the photoelectrode and the photoelectrode substrate when the electrons are transferred to the photoelectrode substrate, but also suppress the reunion of the electrons with the dye sensitizing agent in an oxidation state to thereby prevent the reverse transfer of electrons. Consequently, the conversion efficiency of the dye-sensitized solar cell can be significantly increased.

The blocking layer is preferably an n-type semiconductor.

It is preferable that the blocking layer be at least one material layer selected from the group consisting of a layer of titanium oxide, a layer of aluminium oxide, a layer of silicon oxide, a layer of zirconium oxide, a layer of strontium titanate, a layer of magnesium oxide, and a layer of niobium oxide. Because at least one material is selected from these materials and finely coated on the photoelectrode substrate, reverse electron transfer in the dye-sensitized solar cell can be prevented, and the conversion efficiency can be significantly improved.

The blocking layer can be formed by coating titanium oxide, aluminium oxide, silicon oxide, zirconium oxide, strontium titanate, magnesium oxide, niobium oxide, or the like on the photoelectrode substrate (titanium material).

A coating method is such that a solution containing a precursor of the blocking layer, such as a titanium compound (e.g., titanium tetrachloride), an aluminium compound (e.g., aluminium chloride), a silicon compound, a zirconium compound, a strontium titanate compound, a magnesium compound, or a niobium compound (e.g., niobium chloride), is coated on the photoelectrode substrate by a method such as spin coating, dip coating, squeegee coating, screen printing, or spraying. Then, it is preferable to perform heat treatment (e.g., firing at about 450°C).

The blocking layer can be formed by PVD treatment or CVD treatment, such as sputtering, ion plating, vacuum deposition, or electron beam deposition, of a material, such as a titanium compound, an aluminium compound, a silicon compound, a zirconium compound, a strontium titanate compound, a magnesium compound, or a niobium compound. A fine blocking layer can be thereby easily formed on the titanium material, which is a photoelectrode substrate.

It is more preferable that the blocking layer comprise at least two layers (a two-layer structure or a three-layer structure) selected from the group consisting of a layer of titanium oxide, a layer of aluminium oxide, a layer of silicon oxide, a layer of zirconium oxide, a layer of strontium titanate, a layer of magnesium oxide, and a layer of niobium oxide.

It is more preferable that the blocking layer comprise at least two layers (a two-layer structure or a three-layer structure) selected from the group consisting of a layer of titanium oxide, a layer of aluminium oxide, and a layer of niobium oxide.

The film thickness of the blocking layer can be changed depending on the type of substance and the coating method. The film thickness of the blocking layer is preferably about 0.1 nm to 10 µm, and more preferably about 1 nm to 1 µm.

It is preferable that a blocking layer having a two-layer structure comprise a layer of aluminium oxide as the lower layer (titanium material side) and a layer of titanium oxide as the upper layer (electrolyte layer or porous titanium oxide side).

It is preferable that a blocking layer having a two-layer structure comprise a layer of niobium oxide as the lower layer (titanium material side), and a layer of titanium oxide as the upper layer (electrolyte layer or porous titanium oxide side).

It is preferable that a blocking layer having a three-layer structure comprise a layer of aluminium oxide as the lower layer (titanium material side), a layer of niobium oxide as the intermediate layer, and a layer of titanium oxide as the upper layer (electrolyte layer or porous titanium oxide side).

### Titanium Oxide Layer

In the photoelectrode, a titanium oxide layer (semiconductor layer) containing a dye sensitizing agent is formed on a titanium material (a material selected from the group consisting of metal titanium, titanium alloys, surface-treated metal titanium, and surface-treated titanium alloys).

The titanium oxide layer is preferably porous.

The semiconductor layer may be formed as an anatase-type titanium oxide film prepared by the above surface treatment method A or B. Further, a (porous) titanium oxide layer can be formed by the step of performing heat treatment under an oxidizing atmosphere after applying a paste agent containing particles of titanium oxide, etc.

When UV ozone treatment or the like is performed before the application of the paste agent containing particles of titanium oxide, etc., the wettability of the photoelectrode substrate is improved, and an excellent titanium oxide layer is formed.

The average particle diameter of titanium oxide particles is preferably about 0.1 to 3,000 nm, more preferably about 1 to 1,000 nm, and even more preferably about 10 to 500 nm. It is not necessary to use a single titanium oxide particle powder, and a mixture of a powder having a small particle size and a powder having a large particle size allows light to be scattered in the titanium oxide layer; thus, the photoelectric conversion efficiency of the obtained dye-sensitized solar cell can be improved.

The paste agent is prepared by, for example, dispersing titanium oxide particles in a solvent. The solvent is preferably polyethylene glycol. The content of titanium oxide particles in the paste agent is not particularly limited, and may be appropriately adjusted so that a sintered body is suitably formed.

The method for applying a paste agent to the titanium material is not particularly limited. For example, screen printing, inkjet printing, roll coating, doctor blading, spray coating, etc., can be used.

The thickness of the coating film after applying the paste agent is not particularly limited, and may be suitably determined so that a titanium oxide sintered body having a desired thickness is formed.

The (porous) titanium oxide layer is preferably applied in a rectangular shape. The titanium oxide layer applied in a rectangular shape, rather than a square shape, improves photoelectric conversion efficiency, without disappearance of electrons generated due to light excitation of the dye sensitizing agent in the titanium oxide layer.

When the photoelectrode substrate is a surface-treated metal titanium material or titanium alloy material, a laminate of the titanium oxide sintered body and the titanium oxide film is obtained as the (porous) titanium oxide layer.

The temperature of the heat treatment is preferably about 100 to 600°C, and more preferably about 400 to 500°C. In particular, the titanium oxide particles can be suitably sintered together by heat treatment at a temperature of about 400 to 500°C. The time of the heat treatment may be suitably determined depending on the heat treatment temperature, etc. The heat treatment is performed in an oxidizing atmosphere (in an atmosphere in which oxygen is present; e.g., in the air).

### Dye Sensitizing Agent

In the photoelectrode, a titanium oxide layer containing a dye sensitizing agent is formed on a titanium material.

The photoelectrode on which a titanium oxide layer (semiconductor layer) is formed by the above method is immersed in a solution containing a dye sensitizing agent, thereby allowing the dye sensitizing agent to be adsorbed to the titanium oxide layer.

It is preferable to perform UV ozone treatment, etc., before immersion in the dye sensitizing agent, because the dye sensitizing agent is more easily adsorbed to the titanium oxide layer of the dye-sensitized solar cell.

The dye sensitizing agent is not particularly limited, as long as it is dye that can absorb light in the near-infrared light region and the visible light region. Preferred dye sensitizing agents are ruthenium metal complexes, such as red dye (N719) and black dye (N749); metal complexes other than ruthenium, such as copper phthalocyanine; organic complexes, such as eosine, rhodamine, merocyanine, and indoline; and the like.

These dye sensitizing agents can be used singly or in a combination of two or more. Among the dye sensitizing agents, ruthenium complexes are preferred, and a mixture of red dye (N719) and black dye (N749), which can absorb light in the near-infrared light region, is more preferred.

The dye sensitizing agent can be adsorbed to the titanium oxide layer by, for example, immersing the semiconductor layer, such as a titanium oxide layer, in a solution containing the dye sensitizing agent. The dye sensitizing agent can be attached to the semiconductor layer by chemical adsorption, physical adsorption, or deposition.

The amount of dye sensitizing agent attached may be suitably determined depending on the area of the semiconductor layer, etc., within a range that does not impair the effect of the present invention.

### (2) Counter Electrode

The counter electrode is provided with a collector electrode.

The counter electrode of the dye-sensitized solar cell preferably comprises a transparent conductive glass or transparent conductive film provided with a collector electrode, and further coated with an electrochemical-reduction catalyst layer.

The transparent conductive glass or transparent conductive film is obtained by coating a transparent conductive film, such as ITO (indium tin oxide) or FTO (fluorine tin oxide), onto transparent glass or a transparent plastic material, such as PET (polyethylene terephthalate) or PEN (polyethylene naphthalate). A counter electrode in which an electrochemical-reduction catalyst layer is coated on the surface of transparent conductive glass or a transparent conductive film on the electrolyte side by PVD treatment, such as electron-beam deposition or sputtering, is used.

The electrochemical-reduction catalyst layer may be a platinum catalyst layer, a carbon layer, a poly(3,4-ethylenedioxythiophene) (PEDOT) layer, a gold layer, a silver layer, a copper layer, an aluminum layer, a rhodium layer, an indium layer, or the like. The electrochemical-reduction catalyst layer is preferably a platinum catalyst layer because, for example, hydrogen overvoltage is low and electrons are easily injected into the electrolyte that has lost electrons in the electrolyte layer.

Since the photoelectrode of the present invention is made of a titanium material that does not transmit light, light is irradiated from the counter electrode side. The counter electrode requires the use of a transparent conductive glass or transparent conductive film having a relatively high sheet resistance; therefore, the resistance of the counter electrode was sometimes a problem in the production of dye-sensitized solar cells having a large area. Although the current amount to be generated was increased along with the increase in the area of dye-sensitized solar cells, the resistance components of the transparent conductive film were also increased to increase the internal series resistance of the solar cell, thereby causing a problem such that conversion efficiency was reduced.

In order to increase the photoelectric conversion efficiency of dye-sensitized solar cells having a large area, it was necessary to reduce the resistance of the counter electrode.

### Collector Electrode

In the present invention, a material having a collecting effect is wired in the form of a stripe, mesh, or the like on the surface of the transparent conductive film, and the conversion efficiency is thereby not reduced even in dye-sensitized solar cells having a large area. The material having a collecting effect is a collector electrode. The collector electrode wired in the form of a stripe, mesh, or the like takes electricity through its terminal. The terminal is preferably one coated with a paste agent, such as silver or solder.

Stripe-like collector electrodes may not take electricity if disconnection failure occurs.

Mesh-like collector electrodes can supplement the drawbacks of stripe-like collector electrodes, and reduce the influence of disconnection failure. Moreover, the collector electrode may be one obtained by fixing a mesh of metal or a carbon material to a transparent conductive film.

In addition to the patterning of a fine stripe, mesh, or like shape on the counter electrode, it is preferable to perform patterning by photolithography that can perform fine patterning in an exposure part and a non-exposure part by applying a photosensitive resist to the substrate, and exposing the resist.

The aperture ratio of the counter electrode of the present invention is preferably 50 to 99%, more preferably 70 to 99%, and even more preferably 80 to 95%, of the entire area of the counter electrode.

In the present invention, any material that has electrical conductivity can be preferably used as the collector electrode material.

It is preferable that the collector electrode provided in the counter electrode be metal selected from the group consisting of gold, silver, copper, platinum, rhodium, palladium, iridium, aluminum, nickel, titanium, niobium, tantalum, zirconium, tungsten, nickel, chromium, and molybdenum; or an alloy comprising metal mentioned above as a main component.

It is preferable that the collector electrode provided in the counter electrode be a carbon material selected from the group consisting of carbon, graphite, carbon nanotubes, and fullerenes.

It is preferable that the collector electrode provided in the counter electrode be a conductive polymer material selected from the group consisting of polythiophenes.

When highly corrosive iodine is used as the electrolyte solution layer, it is preferable that the collector electrode be titanium, niobium, tantalum, zirconium, tungsten, chromium, or molybdenum, all of which have excellent corrosion resistance; or a titanium alloy, a niobium alloy, a tantalum alloy, a zirconium alloy, a tungsten alloy, a chromium alloy, or a molybdenum alloy, all of which comprise metal mentioned above as a main component.

It is also preferable that the collector electrode be a carbon material having excellent corrosion resistance, such as carbon, graphite, carbon nanotubes, or fullerenes; or a conductive polymer material, such as polythiophene.

It is preferable that the collector electrode provided in the counter electrode be at least one material selected from the materials mentioned above. Titanium, titanium alloys, etc., are preferred in terms of profitability and corrosion resistance.

Examples of titanium alloys include Ti-6Al-4V, Ti-4.5Al-3V-2Fe-2Mo, Ti-0.5Pd, Ti-Ni, Ti-5Al-2.5Sn, Ti-8Al-1Mo-1V, Ti-3Al-2.5V, Ti-6Al-6V-2Sn, Ti-6Al-2Sn-4Zr-6Mo, Ti-3Al-2.5V-6Cr-4Zr-4Mo, Ti-10V-2Fe-3Al, Ti-15V-3Cr-3Sn-3Al, Ti-5Al-1Fe, Ti-0.5Cu, Ti-1Cu, Ti-1Cu-0.5Nb, Ti-3Al-5V, Ti-20V-4Al-1Sn, Ti-22V-4Al, and the like.

Preferable titanium alloys are alloys that can improve the conductivity of titanium. Ti-Ni, which contains nickel that is more conductive than titanium, is a preferable material for enhancing the collecting effect of the present invention.

When gold, silver, copper, nickel, aluminum, or the like that may corrode iodine in the electrolyte solution is used, after a collector electrode is provided using such metal, the surface thereof may be coated with titanium or a titanium alloy for use.

When a material to which wet plating can be applied, such as nickel, is used, the method for producing a collector electrode is preferably such that a wiring pattern is printed by ink jet printing, gravure printing, screen printing, or the like using palladium, palladium salt, etc., for electroless plating, and performing electroless plating thereon; or such that electroless plating or electrolytic plating is performed after wiring pattern by photolithography.

When a material to which wet plating cannot be applied, such as titanium, a titanium alloy, etc., is used, a preferable method is such that after a mask plate of wiring is attached to the counter electrode, a collector electrode is formed by a PVD method, such as EB evaporation, sputtering, or ion plating.

When nickel or the like that corrodes iodine in the electrolyte is used, the metal, such as nickel, is subjected to electroless plating or electrolytic plating, and titanium, a titanium alloy, or the like is coated on the plated metal by a PVD method, such as EB evaporation, sputtering, or ion plating.

In the dye-sensitized solar cell, the counter electrode is preferably obtained by producing a material in which a collector electrode is embedded in a molten thermoplastic polymer material, and coating the surface thereof with a transparent conductive film, followed by coating with an electrochemical-reduction catalyst layer.

Alternatively, the counter electrode may be obtained by producing a material in which a collector electrode is embedded in a molten thermoplastic polymer material having transparency, such as PET (polyethylene terephthalate) or PEN (polyethylene naphthalate), and coating the surface thereof with a transparent conductive film, such as ITO (indium tin oxide) or FTO (fluorine tin oxide), by a PVD method, such as EB evaporation or sputtering, followed by coating with an electrochemical-reduction catalyst layer.

In the dye-sensitized solar cell, the counter electrode is preferably obtained by producing a material in which a collector electrode is embedded in the concave surface of a thermoplastic polymer material or glass material, and coating the surface thereof with a transparent conductive film, followed by coating with an electrochemical-reduction catalyst layer.

Alternatively, the counter electrode may be obtained by embedding a collector electrode in a concave surface previously provided on the surface of PET, PEN, or glass material, and coating the surface thereof with a transparent conductive film, such as ITO (indium tin oxide) or FTO (fluorine tin oxide), by a PVD method, such as EB evaporation or sputtering, followed by coating with an electrochemical-reduction catalyst layer.

The thickness of the collecting member is preferably 0.01 to 100 µm, more preferably 0.1 to 10 µm, and even more preferably 1 to 10 µm.

Since the distance in which the electricity flows through the transparent conductive electrode is shorter as the pitch of the collector electrode is narrower, photoelectric conversion efficiency is improved. However, the opening area is reduced as the pitch is narrowed; thus, it is necessary to narrow the line width. Moreover, a narrower line width requires a higher thickness of the collector electrode; therefore, the material of the collector electrode, pitch, line width, and the thickness of the collector electrode were comprehensively examined.

Specifically, in the case of a nickel collector electrode, when the line resistance of the collector electrode is 4.5 Ω/cm and the aperture ratio is 90%,
the line width is 0.8 mm, and the nickel film thickness is 1.88 µm at a pitch of 8 mm;
the line width is 0.5 mm, and the nickel film thickness is 3 µm at a pitch of 5 mm;
the line width is 0.2 mm, and the nickel film thickness is 7.5 µm at a pitch of 2 mm; and
the line width is 0.1 mm, and the nickel film thickness is 15 µm at a pitch of 1 mm.

If the nickel film thickness is 15 µm, not only the stress increases, but also the distance from the counter electrode to the titanium oxide layer to which the dye is adsorbed becomes longer; therefore, a pitch of 1 mm is not preferable, and a pitch of about 2 mm is preferable.

Since light transparency increases as the thickness of the platinum coating film on the counter electrode is thinner, coating with several nm or less is preferred. When the coating film thickness is overly thin, electrons are less likely to be injected into the electrolyte that has lost electrons in the electrolyte solution, and the photoelectric conversion efficiency of the obtained dye-sensitized solar cell is thus reduced. Accordingly, the thickness of the platinum layer is more preferably about 0.5 to 1 nm.

In order to increase the amount of light entering the dye-sensitized solar cell, an antireflection film is formed on the light irradiation surface of transparent conductive glass or a transparent conductive film, which serves as the counter electrode, by a method such as dry treatment (e.g., vacuum deposition or sputtering), spin coating, or dip coating, using MgF² or SiO²; or an antireflection film is attached to the light irradiation surface. As a result, the photoelectric conversion efficiency of the obtained dye-sensitized solar cell is improved.

### (3) Electrolyte Layer

The electrolyte layer may be a layer that can be excited by light, supply electrons to the dye sensitizing agent achieving electron injection into the semiconductor layer, and reduce the dye sensitizing agent. The electrolyte layer may also be a layer in which electrons are supplied from the platinum catalyst layer of the counter electrode to the electrolyte that has lost electrons.

A liquid electrolyte layer is, for example, a non-aqueous electrolyte solution containing a redox species. Preferred examples of the redox species include a combination of iodine and an iodide salt, such as lithium iodide, sodium iodide, potassium iodide, or calcium iodide; and a combination of bromine and a bromide salt, such as lithium bromide, sodium bromide, potassium bromide, or calcium bromide. These may be used singly or in a combination of two or more. Further, DMPII (1,2-dimethyl-3-propylimidazolium iodide), TBP (tert-butylpyridine), etc., may be added.

Examples of the solvent include acetonitrile, 3-methoxy propionitrile, ethylene carbonate, propione carbonate, γ-butyrolactone, and the like. These solvents may be used singly or in a combination of two or more.

In the dye-sensitized solar cell of the present invention, the dye adsorbed to the titanium oxide layer on the photoelectrode is irradiated with light via a light-concentrating device, the counter electrode material, and the electrolyte solution layer to excite the dye by the light; thus, the electrolyte solution layer is required to have high light transparency.

The thickness of the electrolyte layer, that is, the distance between the photoelectrode and the counter electrode, is preferably 25 to 100 µm, and more preferably 25 to 50 µm.

### (4) Separator (Spacer) and Sealing Material

In the dye-sensitized solar cell, a separator (spacer) is preferably disposed so as to prevent contact between the photoelectrode and the counter electrode.

The thickness of the separator (spacer) disposed between the photoelectrode and the counter electrode determines the thickness of the electrolyte solution layer. In the dye-sensitized solar cell of the present invention, as the thickness of the electrolyte solution layer is thinner, the dye adsorbed to the titanium oxide layer on the photoelectrode is more irradiated with light via a light-concentrating device, the counter electrode material, and the electrolyte solution layer to excite the dye by the light; thus, the electrolyte solution layer is required to have high light transparency, and the thickness of the electrolyte solution layer is preferably thin.

A separator (spacer) that is too thin allows contact between the photoelectrode and the counter electrode. The thickness of the separator (spacer) is preferably 25 to 100 µm, and more preferably 25 to 50 µm.

As the separator, a known separator generally used in the field of cells can be used. The separator may be an ionomer resin film, polyimide resin film, UV-cured acrylic resin, glass material, silane-modified polymer, polyimide tape, or the like.

The area of the separator is not particularly limited, and may be suitably determined depending on the scale of the target solar cell, etc.

Examples of the sealing material include UV-cured acrylic resin, ionomer resin films, epoxy resin, polyester resin, acrylic resin, hot melt resin, silicone elastomers, butyl rubber elastomers, glass materials, and the like. TB3017B (produced by ThreeBond) can be used as the UV-cured acrylic resin. The sealing material can seal the gap between the photoelectrode and the counter electrode.

### (5) Light-Concentrating Device

If a light-concentrating device is disposed on the counter electrode side in the present dye-sensitized solar cell, high power generation that corresponds to higher photoelectric conversion efficiency is possible.

A light irradiation means is disposed on the counter electrode side via the light-concentrating device. Since the photoelectrode of the dye-sensitized solar cell is made of a titanium material that does not transmit light, light is irradiated from the counter electrode side. The light-concentrating device disposed between the counter electrode and the light source concentrates wastefully used light, achieving high electrical power that corresponds to high photoelectric conversion efficiency.

Conventional dye-sensitized solar cells using transparent conductive films, such as ITO (indium tin oxide) and FTO (fluorine tin oxide), have high sheet resistance. In particular, the photoelectric conversion efficiency of dye-sensitized solar cells with a large area is not improved even when light is converged by a light-concentrating device.

On the other hand, the metal titanium, titanium alloy, surface-treated metal titanium material, or surface-treated titanium alloy material used in the photoelectrode of the present invention has advantages in that it has significantly lower sheet resistance than transparent conductive films, such as ITO (indium tin oxide) and FTO (fluorine tin oxide). Therefore, even when the dye-sensitized solar cell of the present invention has a large area, electrical power corresponding to the photoelectric conversion efficiency of the dye-sensitized solar cell can be obtained by converging light using a light-concentrating device.

The condensing rate when incident light is converged by a light-concentrating device is preferably about 110 to 5,000%, more preferably about 200 to 4,000%, even more preferably about 300 to 3,000%, and particularly preferably about 500 to 900%. For example, a condensing rate of 500% means that the original incident light is converged 5 times by a light-concentrating device.

The light-concentrating device is not particularly limited; however, it is preferable to use glass or a condenser lens, such as a transparent plastic linear Fresnel lens (e.g., PMMA (polymethyl methacrylate), PET (polyethylene terephthalate), or PEN (polyethylene naphthalate)).

Organic components, including the dye sensitizing agent, used in the dye-sensitized solar cell may be deteriorated by short-wavelength ultraviolet rays contained in sunlight. Therefore, a light-concentrating device, such as glass or a transparent plastic linear Fresnel lens (e.g., PMMA (polymethyl methacrylate), PET (polyethylene terephthalate), or PEN (polyethylene naphthalate)), can be used to prevent the entrance of short-wavelength ultraviolet rays contained in sunlight into the dye-sensitized solar cell. The deterioration of organic components, including dye, used in the dye-sensitized solar cell can be prevented, and the durability of the dye-sensitized solar cell can be improved.

### (6) Method for Producing Dye-Sensitized Solar Cell

The dye-sensitized solar cell of the present invention can be produced by a known method.

For example, a photoelectrode and a counter electrode are disposed opposite to each other via a spacer, and an electrolyte layer is sealed between the photoelectrode and the counter electrode. The method for sealing the electrolyte layer is not limited. For example, after the counter electrode is laminated on the semiconductor layer side of the photoelectrode, an inlet is provided, and a material constituting the electrolyte layer is injected through the inlet. The inlet may be sealed with a predetermined member or resin after the injection of the material is completed.

Moreover, when the electrolyte layer is a gel, it may be liquefied by heating when the above material is injected. When the electrolyte layer is solid, for example, a solution in which the solid electrolyte is dissolved is prepared using a solvent that can dissolve the solid electrolyte, the solution is injected into the inlet, and the solvent is then removed.

The dye-sensitized solar cell of the present invention is a next-generation solar cell with high photoelectric conversion efficiency. The dye-sensitized solar cell of the present invention can have a module form comprising a plurality of cells.

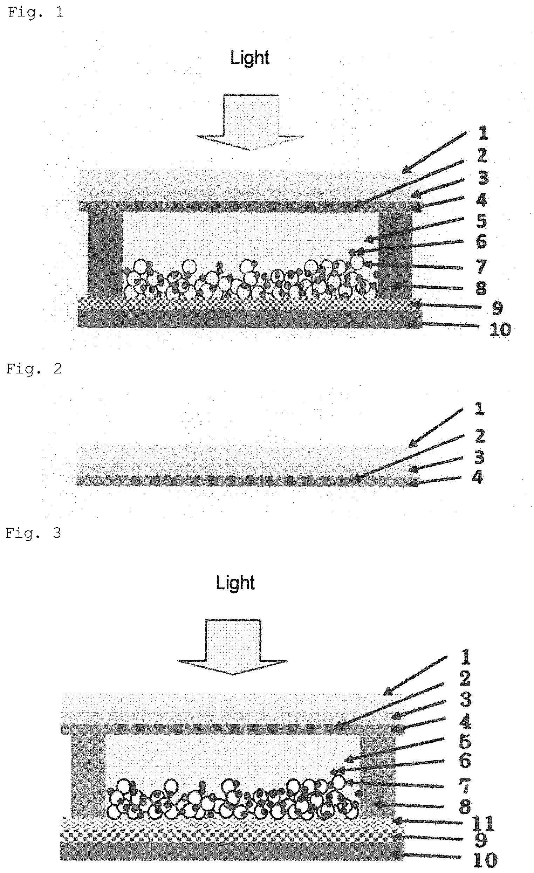

Fig. 1 is a schematic view (cross-sectional view) showing one embodiment of the dye-sensitized solar cell of the present invention.

Fig. 2 is a schematic view (cross-sectional view) showing one embodiment of the counter electrode of the dye-sensitized solar cell of the present invention.

Fig. 3 is a schematic view (cross-sectional view) showing one embodiment of the dye-sensitized solar cell of the present invention.

### Examples

The present invention is described below with reference to Examples; however, the present invention is not limited to these Examples.

### Example 1

### (1) Production of Anodized Titanium Material

A metal titanium plate (titanium material, photoelectrode substrate) was degreased with trichloroethylene. Using a nitriding furnace (NVF-600-PC, produced by Nakanihon-Ro Kogyo Co., Ltd.), titanium nitride was formed on the surface of the degreased metal titanium plate.

First, the metal titanium plate was held by a plate carbon material placed in the nitriding furnace. Subsequently, in order to remove oxygen, the pressure in the nitriding furnace was reduced to 1 Pa or less, and then high-purity (99.99% or more) nitrogen gas was introduced into the nitriding furnace to return the pressure to 0.1 MPa (atmospheric pressure). Then, the temperature of the nitriding furnace was raised to 950°C for 2 hours. Thereafter, heat treatment was performed in the nitriding furnace at 950°C for 1 hour, thereby forming titanium nitride on the surface of the metal titanium plate.

The metal titanium plate with titanium nitride formed on the surface thereof was anodized with 1.5 M sulfuric acid (produced by Wako Pure Chemical Industries, Ltd.), 0.05 M phosphoric acid (produced by Wako Pure Chemical Industries, Ltd.), and 0.3 M hydrogen peroxide (produced by Wako Pure Chemical Industries, Ltd.) at a current density of 4 A/dm² for 30 minutes. Thus, an anatase-type titanium oxide film was formed.

### (2) Production of Photoelectrode

A dye-sensitized solar cell was produced using the above surface-treated metal titanium plate (50 mm x 50 mm) as a photoelectrode.

First, the surface-treated metal titanium plate was washed with a solvent, and then an oxygen flow was applied (0.05 MPa, 5 min) in a UV ozone cleaner (UV253S, produced by Filgen, Inc.). After ultraviolet irradiation for 30 minutes, a nitrogen flow was further applied (0.2 MPa, 7.5 min).

After this treatment, the surface-treated material was coated with a titanium oxide material (PST-18NR, produced by JGC Catalysts and Chemicals Ltd.) by a squeegee method so that the coated area was 16 cm² (40 mm x 40 mm), followed by firing at 450°C for 15 minutes. This material was coated 10 times so that the film thickness was 30 µm (semiconductor layer, (porous) titanium oxide layer), followed by firing at 450°C for 1 hour.

Further, an oxygen flow was applied (0.05 MPa, 5 min) in a UV ozone cleaner (UV253S, produced by Filgen, Inc.). After ultraviolet irradiation for 30 minutes, a nitrogen flow was further applied (0.2 MPa, 7.5 min).

Subsequently, 0.45 mM ruthenium-based dye N719 (dye sensitizing agent, produced by Solaronix) and 0.15 mM ruthenium-based dye N749 (dye sensitizing agent, produced by Solaronix) were diluted in a mixture of tert-butanol (t-BtOH) (produced by Wako Pure Chemical Industries, Ltd.) and acetonitrile (CH₃CN) (produced by Wako Pure Chemical Industries, Ltd.) to prepare a dye solution. The mixing ratio of t-BtOH to CH₃CN in the mixture was 1:1.

The metal titanium plate after firing was immersed in the dye solution at 40°C for 14 hours, thereby forming a (porous) titanium oxide layer containing a dye sensitizing agent. Thus, a photoelectrode material was obtained.

The surface-treated metal titanium was ground with a precision grinder (AC-D12, produced by Sunhayato Corp.) to thereby provide a collecting part.

### (3) Production of Counter Electrode Plate

The counter electrode used was obtained by irradiating an FTO (fluorine tin oxide)-deposited (coated) glass plate (produced by Asahi Glass Co., Ltd.) (transparent conductive glass) with a low-pressure mercury lamp for 10 minutes, followed by UV ozone cleaning.

A wiring pattern was formed on the cleaned substrate by ink-jetting using 0.5 wt% palladium acetate/DGME (diethylene glycol monomethyl ether) catalyst ink so that the line width was 100 µm and the length was 49 mm. Then, the substrate was dried in a hot-air oven at 100°C for 10 minutes, and washed with running distilled water for 10 seconds.

Two types of plates in which the line intervals were 5-mm pitch and 8-mm pitch were prepared.

### Collector Electrode (Ni)

Next, the substrate was immersed in an electroless nickel plating solution (ICP Nicoron GME (NP), produced by Okuno Chemical Industries Co., Ltd.) at 80°C for 4 minutes, and washed with running distilled water for 10 seconds. Then, the substrate was further immersed in the same plating solution for 60 minutes at 60°C, and washed with water, thereby providing nickel-plated wiring having a line width of 500 µm and a thickness of 3 µm.

A material (50 mm X 50 mm) obtained by electron-beam deposition of 1-nm platinum on the substrate provided with nickel-plated wiring was used as a counter electrode plate. The counter electrode plate was coated with silver paste (Dotite D-550, produced by Fujikurakasei Co., Ltd.), thereby providing a collecting part.

Further, a comparative counter electrode plate was also produced by electron-beam deposition of 1-nm platinum (electrochemical-reduction catalyst layer) on an FTO-deposited (coated) glass plate (transparent conductive glass).

### (4) Production of Dye-Sensitized Solar Cell

A 30-µm-thick ionomer resin spacer (Himilan, produced by DuPont-Mitsui Polychemicals Co., Ltd.) was placed in the gap between the photoelectrode and the counter electrode.

Then, 0.01 M I₂ (iodine), 0.02 M LiI (lithium iodide), 0.24 M DMPII (1,2-dimethyl-3-propylimidazolium iodide), and 1.0 M TBP (tert-butylpyridine) were dissolved in acetonitrile (produced by Wako Pure Chemical Industries, Ltd.) to prepare an electrolyte solution. The prepared electrolyte solution was placed in the gap between the photoelectrode and the counter electrode (electrolyte layer).

Subsequently, the gap between both electrodes was sealed with a UV-cured acrylic resin (TB3017B, sealing material, produced by ThreeBond). The sealing material was cured by using a conveyor-type UV irradiation apparatus (VB-15201BY-A, produced by Ushio Inc.) with an integrated intensity of 40 kJ/m². Thus, dye-sensitized solar cells were produced.

### (5) Evaluation Results

Table 1 shows the results of examining the photoelectric conversion efficiency of the dye-sensitized solar cells comprising a substrate in which nickel-plated wiring was provided as a collector electrode on a counter electrode plate.

### Table 1

| Table 1 | | | | | | |
|---|---|---|---|---|---|---|
| Pitch | Aperture ratio | Consideration of aperture ratio | Short-circuit current density (mA/cm²) | Open voltage (V) | Fill factor | Photoelectric conversion efficiency (%) |
| 5 mm | 0.9 | Not considered | 6.24 | 0.734 | 0.536 | 2.45 |
| | | Considered | 6.50 | 0.734 | 0.536 | 2.56 |
| 8 mm | 0.94 | Not considered | 6.43 | 0.726 | 0.477 | 2.22 |
| | | Considered | 6.70 | 0.726 | 0.477 | 2.32 |
| No collector electrode | | | 7.06 | 0.718 | 0.315 | 1.60 |

The above results indicate that although the short-circuit current density was reduced in an amount corresponding to the reduction in the aperture ratio due to wiring, the fill factor was improved and the photoelectric conversion efficiency was increased due to the effect of reducing the resistance of the counter electrode plate by providing nickel-plated wiring as a collector electrode.

Moreover, higher effects were obtained when the pitch was 5 mm, rather than 8 mm, because the distance of electricity flowing through the transparent electrode was shorter at a pitch of 5 mm.

### Example 2

### (1) Production of Anodized Titanium Material

A metal titanium plate (titanium material, photoelectrode substrate) was degreased with trichloroethylene. Using a nitriding furnace (NVF-600-PC, produced by Nakanihon-Ro Kogyo Co., Ltd.), titanium nitride was formed on the surface of the degreased metal titanium plate.

First, the metal titanium plate was held by a plate carbon material placed in the nitriding furnace. Subsequently, in order to remove oxygen, the pressure in the nitriding furnace was reduced to 1 Pa or less, and then high-purity (99.99% or more) nitrogen gas was introduced into the nitriding furnace to return the pressure to 0.1 MPa (atmospheric pressure).

Then, the temperature of the nitriding furnace was raised to 950°C for 2 hours. Thereafter, heat treatment was performed in the nitriding furnace at 950°C for 1 hour, thereby forming titanium nitride on the surface of the metal titanium plate.

The metal titanium plate with titanium nitride formed on the surface thereof was anodized with 1.5 M sulfuric acid (produced by Wako Pure Chemical Industries, Ltd.), 0.05 M phosphoric acid (produced by Wako Pure Chemical Industries, Ltd.), and 0.3 M hydrogen peroxide (produced by Wako Pure Chemical Industries, Ltd.) at a current density of 4 A/dm² for 30 minutes. Thus, an anatase-type titanium oxide film was formed.

### (2) Production of Photoelectrode

A dye-sensitized solar cell was produced using the above surface-treated metal titanium plate (50 mm x 50 mm) as a photoelectrode.

First, the surface-treated metal titanium plate was washed with a solvent, and then an oxygen flow was applied (0.05 MPa, 5 min) in a UV ozone cleaner (UV253S, produced by Filgen, Inc.). After ultraviolet irradiation for 30 minutes, a nitrogen flow was further applied (0.2 MPa, 7.5 min).

After this treatment, the surface-treated material was coated with a titanium oxide material (PST-18NR, produced by JGC Catalysts and Chemicals Ltd.) by a squeegee method so that the coated area was 16 cm² (40 mm x 40 mm), followed by firing at 450°C for 15 minutes. This material was coated 10 times so that the film thickness was 30 µm (semiconductor layer, (porous) titanium oxide layer), followed by firing at 450°C for 1 hour.

Further, an oxygen flow was applied (0.05 MPa, 5 min) in a UV ozone cleaner (UV253S, produced by Filgen, Inc.). After ultraviolet irradiation for 30 minutes, a nitrogen flow was further applied (0.2 MPa, 7.5 min).

Subsequently, 0.45 mM ruthenium-based dye N719 (dye sensitizing agent, produced by Solaronix) and 0.15 mM ruthenium-based dye N749 (dye sensitizing agent, produced by Solaronix) were diluted in a mixture of tert-butanol (t-BtOH) (produced by Wako Pure Chemical Industries, Ltd.) and acetonitrile (CH₃CN) (produced by Wako Pure Chemical Industries, Ltd.) to prepare a dye solution. The mixing ratio of t-BtOH to CH₃CN in the mixture was 1:1.

The metal titanium plate after firing was immersed in the dye solution at 40°C for 14 hours, thereby forming a (porous) titanium oxide layer containing a dye sensitizing agent. Thus, a photoelectrode material was obtained.

The surface-treated metal titanium was ground with a precision grinder (AC-D12, produced by Sunhayato Corp.) to thereby provide a collecting part.

### (3) Production of Counter Electrode Plate

The counter electrode used was obtained by attaching a stainless steel (SUS304) plate (thickness: 0.2 mm) provided with an opening (line width: 500 µm x 48 mm) by photo-etching to an FTO (fluorine tin oxide)-deposited (coated) glass plate (produced by Asahi Glass Co., Ltd.) (transparent conductive glass) using a polyimide tape (PB416-10-30, produced by Chyun Yih Tape Co., Ltd.).

Two types of plates in which the line intervals were 5-mm pitch and 8-mm pitch were prepared.

### Collector Electrode (Ni-Ti)

Next, nickel titanium wiring (line width: 500 µm, thickness: 1 µm) was provided by electron-beam deposition of 1 µm nickel titanium material (KIOKALLOY-R, produced by Daido Steel Co., Ltd.).

A material (50 mm X 50 mm) obtained by electron-beam deposition of 1-nm platinum on the substrate provided with nickel titanium wiring was used as a counter electrode plate. The counter electrode plate was coated with silver paste (Dotite D-550, produced by Fujikurakasei Co., Ltd.) (terminal), thereby providing a collecting part. Further, a comparative counter electrode plate was also produced by electron-beam deposition of 1-nm platinum on an FTO-deposited glass plate.

### (4) Production of Dye-Sensitized Solar Cell

A 30-µm-thick ionomer resin spacer (Himilan, produced by DuPont-Mitsui Polychemicals Co., Ltd.) was placed in the gap between the photoelectrode and the counter electrode.

Then, 0.01 M I₂ (iodine), 0.02 M LiI (lithium iodide), 0.24 M DMPII (1,2-dimethyl-3-propylimidazolium iodide), and 1.0 M TBP (tert-butylpyridine) were dissolved in acetonitrile (produced by Wako Pure Chemical Industries, Ltd.) to prepare an electrolyte solution. The prepared electrolyte solution was placed in the gap between the photoelectrode and the counter electrode (electrolyte layer).

Subsequently, the gap between both electrodes was sealed with a UV-cured acrylic resin (TB3017B, sealing material, produced by ThreeBond). The sealing material was cured by using a conveyor-type UV irradiation apparatus (VB-15201BY-A, produced by Ushio Inc.) with an integrated intensity of 40 kJ/m². Thus, dye-sensitized solar cells were produced.

### (5) Evaluation Results

Table 2 shows the results of examining the photoelectric conversion efficiency of the dye-sensitized solar cells comprising a substrate in which nickel titanium wiring was provided on a counter electrode plate.

### Table 2

| Table 2 | | | | | | |
|---|---|---|---|---|---|---|
| Pitch | Aperture ratio | Consideration of aperture ratio | Short-circuit current density (mA/cm²) | Open voltage (V) | Fill factor | Photoelectric conversion efficiency (%) |
| 5 mm | 0.9 | Not considered | 7.94 | 0.766 | 0.360 | 2.19 |
| | | Considered | 8.82 | 0.766 | 0.360 | 2.43 |
| 8 mm | 0.94 | Not considered | 8.21 | 0.764 | 0.361 | 2.26 |
| | | Considered | 8.75 | 0.764 | 0.361 | 2.41 |
| No collector electrode | | | 8.57 | 0.723 | 0.309 | 1.91 |

The above results indicate that the fill factor was improved and the photoelectric conversion efficiency was increased due to the effect of reducing the resistance of the counter electrode plate by providing nickel titanium wiring.

### Example 3

### (1) Production of Anodized Titanium Material

A metal titanium plate (titanium material, photoelectrode substrate) was degreased with trichloroethylene. Using a nitriding furnace (NVF-600-PC, produced by Nakanihon-Ro Kogyo Co., Ltd.), titanium nitride was formed on the surface of the degreased metal titanium plate.

First, the metal titanium plate was held by a plate carbon material placed in the nitriding furnace. Subsequently, in order to remove oxygen, the pressure in the nitriding furnace was reduced to 1 Pa or less, and then high-purity (99.99% or more) nitrogen gas was introduced into the nitriding furnace to return the pressure to 0.1 MPa (atmospheric pressure). Then, the temperature of the nitriding furnace was raised to 950°C for 2 hours. Then, the temperature of the nitriding furnace was raised to 950°C for 2 hours. Thereafter, heat treatment was performed in the nitriding furnace at 950°C for 1 hour, thereby forming titanium nitride on the surface of the metal titanium plate.

The metal titanium plate with titanium nitride formed on the surface thereof was anodized with 1.5 M sulfuric acid (produced by Wako Pure Chemical Industries, Ltd.), 0.05 M phosphoric acid (produced by Wako Pure Chemical Industries, Ltd.), and 0.3 M hydrogen peroxide (produced by Wako Pure Chemical Industries, Ltd.) at a current density of 4 A/dm² for 30 minutes. Thus, an anatase-type titanium oxide film was formed.

### (2) Production of Photoelectrode

A dye-sensitized solar cell was produced using the above surface-treated metal titanium plate (50 mm x 50 mm) as a photoelectrode.

First, the surface-treated metal titanium plate was washed with a solvent, and then an oxygen flow was applied (0.05 MPa, 5 min) in a UV ozone cleaner (UV253S, produced by Filgen, Inc.). After ultraviolet irradiation for 30 minutes, a nitrogen flow was further applied (0.2 MPa, 7.5 min).

After this treatment, the surface-treated material was coated with a titanium oxide material (PST-18NR, produced by JGC Catalysts and Chemicals Ltd.) by a squeegee method so that the coated area was 16 cm² (40 mm x 40 mm), followed by firing at 450°C for 15 minutes. This material was coated 10 times so that the film thickness was 30 µm (semiconductor layer, (porous) titanium oxide layer), followed by firing at 450°C for 1 hour.

Further, an oxygen flow was applied (0.05 MPa, 5 min) in a UV ozone cleaner (UV253S, produced by Filgen, Inc.). After ultraviolet irradiation for 30 minutes, a nitrogen flow was further applied (0.2 MPa, 7.5 min).

Subsequently, 0.45 mM ruthenium-based dye N719 (dye sensitizing agent, produced by Solaronix) and 0.15 mM ruthenium-based dye N749 (dye sensitizing agent, produced by Solaronix) were diluted in a mixture of tert-butanol (t-BtOH) (produced by Wako Pure Chemical Industries, Ltd.) and acetonitrile (CH₃CN) (produced by Wako Pure Chemical Industries, Ltd.) to prepare a dye solution. The mixing ratio of t-BtOH to CH₃CN in the mixture was 1:1.

The metal titanium plate after firing was immersed in the dye solution at 40°C for 14 hours, thereby forming a (porous) titanium oxide layer containing a dye sensitizing agent. Thus, a photoelectrode material was obtained.

The surface-treated metal titanium was ground with a precision grinder (AC-D12, produced by Sunhayato Corp.) to thereby provide a collecting part.

### (3) Production of Counter Electrode Plate

The counter electrode used was obtained by attaching a stainless steel (SUS304) plate (thickness: 0.2 mm) provided with an opening (line width: 500 µm x 48 mm) by photo-etching to an FTO (fluorine tin oxide)-deposited (coated) glass plate (produced by Asahi Glass Co., Ltd.) (transparent conductive glass) using a polyimide tape (PB416-10-30, produced by Chyun Yih Tape Co., Ltd.).

Two types of plates in which the line intervals were 5-mm pitch and 8-mm pitch were prepared.

### Collector Electrode (Ti)

Next, titanium wiring (line width: 500 µm, thickness: 1 µm) was provided by electron-beam deposition of 1-µm titanium material.

A material (50 mm X 50 mm) obtained by electron-beam deposition of 1-nm platinum on the substrate provided with titanium wiring was used as a counter electrode plate. The counter electrode plate was coated with silver paste (Dotite D-550, produced by Fujikurakasei Co., Ltd.) (terminal), thereby providing a collecting part. Further, a comparative counter electrode plate was also produced by electron-beam deposition of 1-nm platinum on an FTO-deposited glass plate.

### (4) Production of Dye-Sensitized Solar Cell

A 30-µm-thick ionomer resin spacer (Himilan, produced by DuPont-Mitsui Polychemicals Co., Ltd.) was placed in the gap between the photoelectrode and the counter electrode.

Then, 0.01 M I₂ (iodine), 0.02 M LiI (lithium iodide), 0.24 M DMPII (1,2-dimethyl-3-propylimidazolium iodide), and 1.0 M TBP (tert-butylpyridine) were dissolved in acetonitrile (produced by Wako Pure Chemical Industries, Ltd.) to prepare an electrolyte solution. The prepared electrolyte solution was placed in the gap between the photoelectrode and the counter electrode (electrolyte layer).

Subsequently, the gap between both electrodes was sealed with a UV-cured acrylic resin (TB3017B, sealing material, produced by ThreeBond). The sealing material was cured by using a conveyor-type UV irradiation apparatus (VB-15201BY-A, produced by Ushio Inc.) with an integrated intensity of 40 kJ/m². Thus, dye-sensitized solar cells were produced.

### (5) Evaluation Results

Table 3 shows the results of examining the photoelectric conversion efficiency of the dye-sensitized solar cells comprising a substrate in which titanium wiring was provided on a counter electrode plate.

**Table 3**

| Table 3 | | | | | | |
|---|---|---|---|---|---|---|
| Pitch | Aperture ratio | Consideration of aperture ratio | Short-circuit current density (mA/cm²) | Open voltage (V) | Fill factor | Photoelectric conversion efficiency (%) |
| 5 mm | 0.9 | Not considered | 8.89 | 0.741 | 0.338 | 2.23 |
| | | Considered | 9.88 | 0.741 | 0.338 | 2.47 |
| 8 mm | 0.94 | Not considered | 9.24 | 0.731 | 0.316 | 2.13 |
| | | Considered | 9.86 | 0.731 | 0.316 | 2.28 |
| No collector electrode | | | 8.64 | 0.723 | 0.309 | 1.93 |

The above results indicate that the fill factor was improved and the photoelectric conversion efficiency was increased due to the effect of reducing the resistance of the counter electrode plate wired with titanium as a collector electrode.

### Example 4

### (1) Production of Anodized Titanium Material

A metal titanium plate (titanium material, photoelectrode substrate) was degreased with trichloroethylene. Using a nitriding furnace (NVF-600-PC, produced by Nakanihon-Ro Kogyo Co., Ltd.), titanium nitride was formed on the surface of the degreased metal titanium plate.

First, the metal titanium plate was held by a plate carbon material placed in the nitriding furnace. Subsequently, in order to remove oxygen, the pressure in the nitriding furnace was reduced to 1 Pa or less, and then high-purity (99.99% or more) nitrogen gas was introduced into the nitriding furnace to return the pressure to 0.1 MPa (atmospheric pressure).

Then, the temperature of the nitriding furnace was raised to 950°C for 2 hours. Thereafter, heat treatment was performed in the nitriding furnace at 950°C for 1 hour, thereby forming titanium nitride on the surface of the metal titanium plate.

The metal titanium plate with titanium nitride formed on the surface thereof was anodized with 1.5 M sulfuric acid (produced by Wako Pure Chemical Industries, Ltd.), 0.05 M phosphoric acid (produced by Wako Pure Chemical Industries, Ltd.), and 0.3 M hydrogen peroxide (produced by Wako Pure Chemical Industries, Ltd.) at a current density of 4 A/dm² for 30 minutes. Thus, an anatase-type titanium oxide film was formed.

### (2) Production of Photoelectrode

A dye-sensitized solar cell was produced using the above surface-treated metal titanium plate (50 mm x 50 mm) as a photoelectrode.

### Blocking Layer (Lower Layer: Aluminium Oxide, Upper Layer: Titanium Oxide)

First, the surface-treated metal titanium plate was washed with a solvent. Then, this material was immersed in a 50 mM aluminium chloride (produced by Wako Pure Chemical Industries, Ltd.) aqueous solution at ordinary temperature for 2 minutes, and then dried, followed by air oxidation at 450°C for 15 minutes.

Next, the material was immersed in a 40 mM titanium tetrachloride (produced by Wako Pure Chemical Industries, Ltd.) aqueous solution at 70°C for 30 minutes, and then dried, followed by air oxidation at 450°C for 15 minutes. The treatment with the aluminium chloride aqueous solution, and the treatment with the titanium tetrachloride aqueous solution resulted in the formation of a blocking layer (two-layer structure) in which a fine aluminum oxide layer was formed in the lower layer (titanium material side), and a fine titanium oxide layer was formed in the upper layer (electrolyte layer or porous titanium oxide side).

After this treatment, the surface-treated material was coated with a titanium oxide material (PST-18NR, produced by JGC Catalysts and Chemicals Ltd.) by a squeegee method so that the coated area was 16 cm² (40 mm x 40 mm), followed by firing at 450°C for 15 minutes (semiconductor layer, (porous) titanium oxide layer).

Subsequently, 0.45 mM ruthenium-based dye N719 (dye sensitizing agent, produced by Solaronix) and 0.15 mM ruthenium-based dye N749 (dye sensitizing agent, produced by Solaronix) were diluted in a mixture of tert-butanol (t-BtOH) (produced by Wako Pure Chemical Industries, Ltd.) and acetonitrile (CH₃CN) (produced by Wako Pure Chemical Industries, Ltd.) to prepare a dye solution. The mixing ratio of t-BtOH to CH₃CN in the mixture was 1:1.

The metal titanium plate after firing was immersed in the dye solution at 40°C for 14 hours, thereby forming a (porous) titanium oxide layer containing a dye sensitizing agent. Thus, a photoelectrode material was obtained.

The surface-treated metal titanium was ground with a precision grinder (AC-D12, produced by Sunhayato Corp.) to thereby provide a collecting part.

### (3) Production of Counter Electrode Plate

As a counter electrode, a glass substrate (thickness: 1 mm x 100 mm x 100 mm) was washed by ultrasonic degreasing with acetone for 15 minutes. Then, the substrate was coated with a titanium film (thickness: 200 nm) by sputtering of titanium. Next, ion plating of titanium was performed to form a titanium layer (thickness: 20 µm).

### Collector Electrode (Ti)

Next, the titanium collecting part was patterned by high-precision photolithography to provide titanium wiring with a line width of 0.5 mm at a pitch of 5 mm.

A material (50 mm X 50 mm) obtained by coating the substrate provided with titanium wiring with an ITO film by sputtering (transparent conductive glass), followed by electron-beam deposition of 1-nm platinum (electrochemical-reduction catalyst layer), was used as a counter electrode plate. A terminal part was provided using Special Solder Cerasolzer #186 (produced by Kuroda Techno Co., Ltd.). Further, a comparative counter electrode plate was also produced by electron-beam deposition of 1-nm platinum on an FTO-deposited glass plate.

### (4) Production of Dye-Sensitized Solar Cell

A 30-µm-thick ionomer resin spacer (Himilan, produced by DuPont-Mitsui Polychemicals Co., Ltd.) was placed in the gap between the photoelectrode and the counter electrode.

Then, 0.01 M I₂ (iodine), 0.02 M LiI (lithium iodide), 0.24 M DMPII (1,2-dimethyl-3-propylimidazolium iodide), and 1.0 M TBP (tert-butylpyridine) were dissolved in acetonitrile (produced by Wako Pure Chemical Industries, Ltd.) to prepare an electrolyte solution. The prepared electrolyte solution was placed in the gap between the photoelectrode and the counter electrode (electrolyte layer).

Subsequently, the gap between both electrodes was sealed with a UV-cured acrylic resin (TB3035B, sealing material, produced by ThreeBond). The sealing material was cured by using a conveyor-type UV irradiation apparatus (VB-15201BY-A, produced by Ushio Inc.) with an integrated intensity of 40 kJ/m². Thus, dye-sensitized solar cells were produced.

### (5) Evaluation Results

Table 4 shows the results of examining the photoelectric conversion efficiency of the dye-sensitized solar cells comprising a substrate in which titanium wiring was provided on a counter electrode plate.

**Table 4**

| Table 4 | | | | | |
|---|---|---|---|---|---|
| Aperture ratio | Consideration of aperture ratio | Short-circuit current density (mA/cm²) | Open voltage (V) | Fill factor | Photoelectric conversion efficiency (%) |
| 90% | Not considered | 7.03 | 0.709 | 0.558 | 2.78 |
| | Considered | 7.81 | 0.709 | 0.558 | 3.09 |
| No collecting part | | 8.57 | 0.726 | 0.325 | 2.02 |

The above results indicate that the fill factor was improved and the photoelectric conversion efficiency was increased due to the effect of reducing the resistance of the counter electrode plate wired with titanium as a collector electrode.

### Example 5

### (1) Production of Anodized Titanium Material

A metal titanium plate (titanium material, photoelectrode substrate) was degreased with trichloroethylene. Using a nitriding furnace (NVF-600-PC, produced by Nakanihon-Ro Kogyo Co., Ltd.), titanium nitride was formed on the surface of the degreased metal titanium plate.

First, the metal titanium plate was held by a plate carbon material placed in the nitriding furnace. Subsequently, in order to remove oxygen, the pressure in the nitriding furnace was reduced to 1 Pa or less, and then high-purity (99.99% or more) nitrogen gas was introduced into the nitriding furnace to return the pressure to 0.1 MPa (atmospheric pressure).

Then, the temperature of the nitriding furnace was raised to 950°C for 2 hours. Thereafter, heat treatment was performed in the nitriding furnace at 950°C for 1 hour, thereby forming titanium nitride on the surface of the metal titanium plate.

The metal titanium plate with titanium nitride formed on the surface thereof was anodized with 1.5 M sulfuric acid (produced by Wako Pure Chemical Industries, Ltd.), 0.05 M phosphoric acid (produced by Wako Pure Chemical Industries, Ltd.), and 0.3 M hydrogen peroxide (produced by Wako Pure Chemical Industries, Ltd.) at a current density of 4 A/dm² for 30 minutes. Thus, an anatase-type titanium oxide film was formed.

### (2) Production of Photoelectrode

A dye-sensitized solar cell was produced using the above surface-treated metal titanium plate (50 mm x 50 mm) as a photoelectrode.

First, the surface-treated metal titanium plate was washed with a solvent, and then an oxygen flow was applied (0.05 MPa, 5 min) in a UV ozone cleaner (UV253S, produced by Filgen, Inc.). After ultraviolet irradiation for 30 minutes, a nitrogen flow was further applied (0.2 MPa, 7.5 min).

### Blocking Layer (Lower Layer: Aluminium Oxide, Upper Layer: Titanium Oxide)

This material was immersed in a 150 mM aluminium chloride (produced by Wako Pure Chemical Industries, Ltd.) aqueous solution at ordinary temperature for 2 minutes, and then dried, followed by air oxidation at 450°C for 15 minutes. This treatment was repeated twice. Next, the material was immersed in a 120 mM titanium tetrachloride (produced by Wako Pure Chemical Industries, Ltd.) aqueous solution at 70°C for 30 minutes, and then dried, followed by air oxidation at 450°C for 15 minutes. This treatment was repeated twice. The treatment with the aluminium chloride aqueous solution, and the treatment with the titanium tetrachloride aqueous solution resulted in the formation of a blocking layer (two-layer structure) in which a fine aluminum oxide layer was formed in the lower layer (titanium material side), and a fine titanium oxide layer was formed in the upper layer (electrolyte layer or porous titanium oxide side).

After this treatment, the surface-treated material was coated with a titanium oxide material (PST-18NR, produced by JGC Catalysts and Chemicals Ltd.) by a squeegee method so that the coated area was 16 cm² (40 mm x 40 mm), followed by firing at 450°C for 15 minutes. This material was coated 5 times so that the film thickness was 15 µm (semiconductor layer), followed by firing at 450°C for 1 hour. Further, an oxygen flow was applied (0.05 MPa, 5 min) in a UV ozone cleaner (UV253S, produced by Filgen, Inc.). After ultraviolet irradiation for 30 minutes, a nitrogen flow was further applied (0.2 MPa, 7.5 min).

Subsequently, 0.45 mM ruthenium-based dye N719 (dye sensitizing agent, produced by Solaronix) and 0.15 mM ruthenium-based dye N749 (dye sensitizing agent, produced by Solaronix) were diluted in a mixture of tert-butanol (t-BtOH) (produced by Wako Pure Chemical Industries, Ltd.) and acetonitrile (CH₃CN) (produced by Wako Pure Chemical Industries, Ltd.) to prepare a dye solution. The mixing ratio of t-BtOH to CH₃CN in the mixture was 1:1. The metal titanium plate after firing was immersed in the present dye solution at 40°C for 14 hours, thereby obtaining a photoelectrode material. The surface-treated metal titanium was ground with a precision grinder (AC-D12, produced by Sunhayato Corp.) to thereby provide a collecting part.

### (3) Production of Counter Electrode Plate

As a counter electrode, a glass substrate (thickness: 1 mm x 100 mm x 100 mm) was washed by ultrasonic degreasing with acetone for 15 minutes. Then, the substrate was coated with a titanium film (thickness: 200 nm) by sputtering of titanium. Next, ion plating of titanium was performed to form a titanium layer (thickness: 20 µm).

### Collector Electrode (Ti)

Next, the titanium collecting part was patterned by high-precision photolithography to provide titanium wiring with a line width of 0.05 mm at a pitch of 0.5 mm, a line width of 0.1 mm at a pitch of 1 mm, and a line width of 0.2 mm at a pitch of 2 mm.

A material (50 mm X 50 mm) obtained by coating the substrate provided with titanium wiring with an ITO film by sputtering, followed by electron-beam deposition of 1-nm platinum was used as a counter electrode plate. A terminal part was provided using Special Solder Cerasolzer #186 (produced by Kuroda Techno Co., Ltd.). Further, a comparative counter electrode plate was also produced by electron-beam deposition of 1-nm platinum on an FTO-deposited glass plate.

### (4) Production of Dye-Sensitized Solar Cell

A 30-µm-thick ionomer resin spacer (Himilan, produced by DuPont-Mitsui Polychemicals Co., Ltd.) was placed in the gap between the photoelectrode and the counter electrode.

Then, 0.01 M I₂ (iodine), 0.02 M LiI (lithium iodide), 0.24 M DMPII (1,2-dimethyl-3-propylimidazolium iodide), and 1.0 M TBP (tert-butylpyridine) were dissolved in acetonitrile (produced by Wako Pure Chemical Industries, Ltd.) to prepare an electrolyte solution. The prepared electrolyte solution was placed in the gap between the photoelectrode and the counter electrode (electrolyte layer).

Subsequently, the gap between both electrodes was sealed with a UV-cured acrylic resin (TB3035B, sealing material, produced by ThreeBond). The sealing material was cured by using a conveyor-type UV irradiation apparatus (VB-15201BY-A, produced by Ushio Inc.) with an integrated intensity of 40 kJ/m². Thus, dye-sensitized solar cells were produced.

### (5) Evaluation Results

Table 5 shows the results of examining the photoelectric conversion efficiency of the dye-sensitized solar cells comprising a substrate in which titanium wiring was provided on a counter electrode plate.

**Table 5**

| Table 5 | | | | | | |
|---|---|---|---|---|---|---|
| Aperture ratio | Pitch | Consideration of aperture ratio | Short-circuit current density (mA/cm²) | Open voltage (V) | Fill factor | Photoelectric conversion efficiency (%) |
| 90% | 0.5 mm | Not considered | 8.55 | 0.744 | 0.562 | 3.57 |
| | | Considered | 9.50 | 0.744 | 0.562 | 3.97 |
| | 1.0mm | Not considered | 9.48 | 0.747 | 0.603 | 4.27 |
| | | Considered | 10.54 | 0.747 | 0.603 | 4.75 |
| | 2.0 mm | Not considered | 9.16 | 0.747 | 0.575 | 3.93 |
| | | Considered | 10.18 | 0.747 | 0.575 | 4.37 |
| No collecting part | | | 9.27 | 0.735 | 0.301 | 2.05 |

The above results indicate that the fill factor was improved and the photoelectric conversion efficiency was increased due to the effect of reducing the resistance of the counter electrode plate wired with titanium as a collector electrode.

### Reference Signs List

- 1.: Glass or film (counter electrode)
- 2.: Collector electrode
- 3.: Conductive film
- 1+3.: Transparent conductive glass or transparent conductive film
- 4.: Electrochemical-reduction catalyst layer
- 5.: Electrolyte layer
- 6.: Dye sensitizing agent
- 7.: Titanium oxide layer
- 8.: Separator, sealing material
- 9.: Anodized layer
- 10.: Metal titanium layer (photoelectrode)
- 11.: Blocking layer

## Claims

1. A dye-sensitized solar cell in which a photoelectrode and a counter electrode are disposed opposite to each other via an electrolyte layer;
(1) the photoelectrode comprising a titanium material and a titanium oxide layer containing a dye sensitizing agent formed on the titanium material; and
(2) the counter electrode comprising a transparent conductive glass or transparent conductive film coated with an electrochemical-reduction catalyst layer, the counter electrode being provided with a collector electrode.

2. The dye-sensitized solar cell according to claim 1, wherein the counter electrode comprises a transparent conductive glass or transparent conductive film provided with a collector electrode, and further coated with an electrochemical-reduction catalyst layer.

3. The dye-sensitized solar cell according to claim 1 or 2, wherein the titanium material is a material selected from the group consisting of metal titanium, titanium alloys, surface-treated metal titanium, and surface-treated titanium alloys.

4. The dye-sensitized solar cell according to any one of claims 1 to 3, wherein the collector electrode provided in the counter electrode is a material selected from the group consisting of highly corrosion-resistant materials.

5. The dye-sensitized solar cell according to any one of claims 1 to 4, wherein the collector electrode provided in the counter electrode is at least one material selected from:
metal selected from the group consisting of gold, silver, copper, platinum, rhodium, palladium, iridium, aluminum, nickel, titanium, niobium, tantalum, zirconium, tungsten, nickel, chromium, and molybdenum;
an alloy comprising metal mentioned above as a main component;
a carbon material selected from the group consisting of carbon, graphite, carbon nanotubes, and fullerenes; or
a conductive polymer material selected from the group consisting of polythiophenes.

6. The dye-sensitized solar cell according to any one of claims 1 to 5, wherein the highly corrosion-resistant material provided in the collector electrode provided in the counter electrode is a material selected from the group consisting of metal titanium and titanium alloys.

7. The dye-sensitized solar cell according to any one of claims 1 to 6, wherein the collector electrode has an opening with an area of 50 to 99% of the entire area of the counter electrode.

8. The dye-sensitized solar cell according to any one of claims 1 to 7, wherein the collector electrode has a thickness of 0.01 to 100 µm.

9. The dye-sensitized solar cell according to any one of claims 1 to 8, wherein the titanium oxide layer has a rectangular shape.

10. The dye-sensitized solar cell according to any one of claims 1 to 9, wherein the electrochemical-reduction catalyst layer is a platinum catalyst layer.

11. The dye-sensitized solar cell according to any one of claims 1 to 10, wherein the transparent conductive glass or transparent conductive film of the counter electrode is subjected to antireflection-film formation.

12. The dye-sensitized solar cell according to any one of claims 1 to 11, wherein the counter electrode further comprises an antireflection film on a light irradiation surface of the transparent conductive glass or transparent conductive film.

13. The dye-sensitized solar cell according to any one of claims 1 to 12, wherein a light-concentrating device is disposed on the counter electrode side.

14. The dye-sensitized solar cell according to any one of claims 1 to 12, wherein the photoelectrode comprises a titanium material, a blocking layer formed on the titanium material, and a titanium oxide layer containing a dye sensitizing agent formed on the blocking layer.

15. The dye-sensitized solar cell according to claim 14, wherein the blocking layer is at least one material layer selected from the group consisting of a layer of titanium oxide, a layer of aluminium oxide, a layer of silicon oxide, a layer of zirconium oxide, a layer of strontium titanate, a layer of magnesium oxide, and a layer of niobium oxide.

16. The dye-sensitized solar cell according to claim 14, wherein the blocking layer comprises at least two layers selected from the group consisting of a layer of titanium oxide, a layer of aluminium oxide, a layer of silicon oxide, a layer of zirconium oxide, a layer of strontium titanate, a layer of magnesium oxide, and a layer of niobium oxide.

17. The dye-sensitized solar cell according to claim 14, wherein the blocking layer comprises at least two layers selected from the group consisting of a layer of titanium oxide, a layer of aluminium oxide, and a layer of niobium oxide.

18. The dye-sensitized solar cell according to any one of claims 1 to 17, wherein the titanium material of the photoelectrode is produced by the following surface treatment method comprising the steps of:
(1) forming titanium nitride on the surface of a metal titanium material or titanium alloy material; and
(2) anodizing the metal titanium material or titanium alloy material with the titanium nitride formed on the surface thereof obtained in step (1) using an electrolyte solution that has an etching effect on titanium at a voltage equal to or higher than spark discharge generating voltage, thereby forming an anatase-type titanium oxide film.

19. The dye-sensitized solar cell according to any one of claims 1 to 17, wherein the titanium material of the photoelectrode is produced by the following surface treatment method comprising the steps of:
(1) forming titanium nitride on the surface of a metal titanium material or titanium alloy material;
(2) anodizing the metal titanium material or titanium alloy material with the titanium nitride formed on the surface thereof obtained in step (1) in an electrolyte solution that does not have an etching effect on titanium; and
(3) heating the anodized metal titanium material or titanium alloy material obtained in step (2) in an oxidizing atmosphere, thereby forming an anatase-type titanium oxide film.

20. The dye-sensitized solar cell according to claim 18 or 19, wherein the step of forming titanium nitride is performed by one treatment method selected from the group consisting of PVD treatment, CVD treatment, spraying treatment, heat treatment under an ammonia gas atmosphere, and heat treatment under a nitrogen gas atmosphere.

21. The dye-sensitized solar cell according to claim 20, wherein the heat treatment under a nitrogen gas atmosphere is performed in the presence of an oxygen-trapping agent.
